# EUROPEAN PATENT APPLICATION

(11) **EP 3 951 499 A1**
(43) Date of publication of application: **09.02.2022**
(21) Application number: 21188838.3
(22) Date of filing: 30.07.2021
(51) Int. Cl.: G03F 7/038, G03F 7/085, G03F 7/40

(54) **NEGATIVE PHOTOSENSITIVE RESIN COMPOSITION, PATTERNING PROCESS, METHOD FOR FORMING CURED FILM, INTERLAYER INSULATION FILM, SURFACE PROTECTIVE FILM, AND ELECTRONIC COMPONENT**

(30) Priority: 04.08.2020 JP 2020132266
(71) Applicant: Shin-Etsu Chemical Co., Ltd., Tokyo (JP)
(72) Inventor: Iio, Masashi, Niigata (JP); Urano, Hiroyuki, Niigata (JP); Watanabe, Osamu, Niigata (JP); Takemura, Katsuya, Niigata (JP)
(74) Representative: Wibbelmann, Jobst

(57) **Abstract**

The present invention is a negative photosensitive resin composition including: (A) an alkali-soluble resin containing at least one or more structures selected from a polyimide structure, a polybenzoxazole structure, a polyamide-imide structure, and a precursor structure thereof; (B) a crosslinkable polymer compound containing a structural unit represented by the following general formula (1) and having a group crosslinked with the component (A); (C) a compound that generates an acid by light; and (D) a heat crosslinking agent. An object of the present invention is to provide a negative photosensitive resin composition that enables formation of a fine pattern with high rectangularity and high resolution, has excellent mechanical characteristics even when cured at low temperatures, and furthermore, has no degradation in adhesive force between before and after a high temperature and high humidity test.

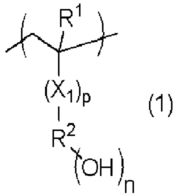

## Description

### TECHNICAL FIELD

The present invention relates to: a negative photosensitive resin composition; a patterning process capable of developing with an alkaline aqueous solution that uses the negative photosensitive resin composition; a method for forming a cured film; an interlayer insulation film; a surface protective film; and an electronic component.

### BACKGROUND ART

As miniaturization and higher performance of various electronic devices such as personal computers, digital cameras, and mobile phones advance, a demand for further miniaturization, thinning and higher density in semiconductor devices are also increasing rapidly. Accompanying these, it is demanded for interlayer insulation films and surface protective films of semiconductor devices to combine excellent electric characteristics, heat resistance, mechanical characteristics and the like.

In a high-density mounting technology such as a three-dimensional lamination, as a photosensitive insulation material capable of forming a pattern on a substrate, a polyimide film has been utilized as a protective film or an insulation layer, its insulation property, mechanical characteristics, and adhesiveness with a substrate, and so forth have continued to draw attention, and its development is active even now.

In recent years, a wiring formation method according to a damascene processing method is proposed as a technique for forming a fine wiring pattern of 2 µm or less, (Non Patent Document 1). In the wiring formation method, the shape of a pattern formed with a photosensitive insulator film material is required to have good rectangularity from the viewpoint of metal wiring formation by electroplating. In addition, from the viewpoint of processing in a CMP process, it is required to have both low warpage of the substrate and excellent mechanical strength.

Polyimide has been said to be useful for surface protective films and interlayer insulation films of semiconductor devices, and wiring protection insulation films for circuit formation. This is because polyimide is excellent in electric characteristics and mechanical characteristics, and has heat resistance to 300°C or higher. Conventionally, as a photosensitive polyimidebased material, a material which uses a polyamic acid, being a polyimide precursor, is proposed, for example, a material having a photosensitive group introduced into a carboxy group of the polyamic acid by an ester bond (Patent Document 1, Patent Document 2). However, in these proposals, imidization treatment at a high temperature exceeding 300°C is indispensable in order to obtain a target polyimide film after formation of a patterned film. Therefore, the proposals involve the problems that an underlying substrate is restricted to endure this high temperature and that the copper of the wiring is oxidized.

As an improvement thereof, a photosensitive polyimide that uses a pre-imidized and solvent-soluble resin has been proposed in order to lower a post-curing temperature (Patent Document 3, Patent Document 4). Patent Document 3 proposes a negative photosensitive composition containing a closed-ring polyimide. However, although resolution is considered, there is only description regarding adhesiveness, and there is no description regarding mechanical strength.

Patent Document 4 proposes a positive photosensitive resin composition that uses an alkali-soluble and closed-ring polyimide, a quinonediazide compound, and a heat crosslinking agent having a methylol group, and the positive photosensitive resin composition is a material excellent in resolution. However, there is no description regarding pattern shape, and there has been room for improving a value of breaking elongation when cured at low temperatures.

Patent Document 5 proposes a negative photosensitive resin composition that uses an alkali-soluble and closed-ring polyimide, a photoradical initiator, a heat crosslinking agent having a methylol group, and a polymerization inhibitor, and the negative photosensitive resin composition is a material excellent in pattern shape with good rectangularity. However, there is no description regarding resolution of fine patterns or mechanical strength.

In addition, to improve the mechanical strength of a cured film, addition of a (meth)acrylic resin is proposed for achieving both lithography characteristics and physical properties of the cured film (Patent Document 6, Patent Document 7, Patent Document 8). Patent Document 6 proposes a positive photosensitive resin composition, where a crosslinkable acrylic resin is added to an alkali-soluble resin having a phenolic hydroxy group. However, consideration of miniaturization and pattern shapes are insufficient, and there has been room for improvement in photosensitive characteristics.

Patent Document 7 and Patent Document 8 propose positive photosensitive resin compositions containing one polymer selected from polyimide, polybenzoxazole, and precursors thereof and an acrylic resin. The positive photosensitive resin compositions are materials excellent in physical properties of the cured film and stress, but there is no mention regarding lithography performance.

Thus, hereafter, as higher densification and higher integration of chips proceed, the miniaturization of patterns in a rewiring technology of the insulation protective film further proceeds. Accordingly, as the photosensitive resin composition, there is strong demand for a composition that can realize high resolution and a pattern shape with favorable rectangularity without damaging excellent features such as the pattern shape obtained by heating and mechanical characteristics, adhesiveness, and so forth of a protective film.

### CITATION LIST

### PATENT LITERATURE

Patent Document 1: JP S49-115541 A
Patent Document 2: JP S55-45746 A
Patent Document 3: JP 2006-133757 A
Patent Document 4: JP 2006-313237 A
Patent Document 5: WO 2016/158389
Patent Document 6: WO 2013/118680
Patent Document 7: JP 2015-129791 A
Patent Document 8: JP 2015-200819 A

### NON PATENT LITERATURE

Non Patent Document 1: Proc. ECTC, Las Vegas, USA, May 29-Jun 01, 2018, pp.587-593

### SUMMARY OF INVENTION

### TECHNICAL PROBLEM

The present invention has been made in view of the above-described circumstances, and an object thereof is to provide a negative photosensitive resin composition that is soluble in an alkaline aqueous solution, that allows formation of a fine pattern with high rectangularity and can achieve high resolution, and that has excellent mechanical characteristics and adhesiveness to a substrate even when cured at low temperatures.

### SOLUTION TO PROBLEM

To solve the problem, the present invention provides
a negative photosensitive resin composition comprising:
(A) an alkali-soluble resin containing at least one or more structures selected from a polyimide structure, a polyamide structure, a polybenzoxazole structure, a polyamide-imide structure, and a precursor structure thereof;
(B) a crosslinkable polymer compound containing a structural unit represented by the following general formula (1) and having a group crosslinked with the component (A);
(C) a compound that generates an acid by light; and
(D) a crosslinking agent other than the component (B), 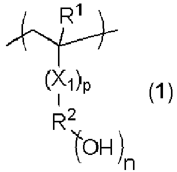
wherein R¹ represents a hydrogen atom or a methyl group, R² represents a linear, branched, or cyclic aliphatic saturated hydrocarbon group with a valency of (n+1) having 1 to 15 carbon atoms, an aromatic hydrocarbon group having 6 to 15 carbon atoms, a benzyl group, or a naphthalene methyl group, wherein a carbon atom of the aliphatic saturated hydrocarbon group is optionally substituted with an oxygen atom; "n" is an integer of 1 to 5; X₁ each represents -C(=O)-O-, -C(=O)-NH-, or - C(=O)-N(R³OH)-; R³ represents a divalent linear, branched, or cyclic aliphatic saturated hydrocarbon group having 1 to 12 carbon atoms, or an aromatic hydrocarbon group having 6 to 12 carbon atoms, wherein a carbon atom of the aliphatic saturated hydrocarbon group is optionally substituted with an oxygen atom; and "p" is 0 or 1.

Such a negative photosensitive resin composition is soluble in an alkaline aqueous solution, enables formation of a fine pattern and high resolution, and has excellent mechanical characteristics and adhesiveness to a substrate even when cured at low temperatures.

Furthermore, the (B) of the inventive negative photosensitive resin composition is preferably a crosslinkable polymer compound containing a structural unit represented by the following general formula (2) and containing a structural unit represented by the following general formula (3), the structural unit having a group crosslinked with the component (A), 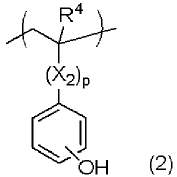 wherein R⁴ represents a hydrogen atom or a methyl group, X₂ each represents -C(=O)-O-, -C(=O)-NH-, or -C(=O)-N(R⁵OH)-; R⁵ represents a divalent linear, branched, or cyclic aliphatic saturated hydrocarbon group having 1 to 12 carbon atoms, or an aromatic hydrocarbon group having 6 to 12 carbon atoms, wherein a carbon atom of the aliphatic saturated hydrocarbon group is optionally substituted with an oxygen atom; and "p" is 0 or 1, 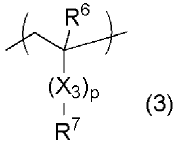 wherein R⁶ represents a hydrogen atom or a methyl group, R⁷ represents a group containing an oxazoline group, an isocyanate group, a blocked isocyanate group, an oxetanyl group, and an epoxy group, X₃ represents - C(=O)-O-, a phenylene group, or a naphthylene group; and "p" is 0 or 1.

Such a negative photosensitive resin composition enables formation of a finer pattern and high resolution, and in addition, mechanical characteristics and adhesiveness to a substrate become excellent even when cured at low temperatures.

Furthermore, the component (B) is preferably a crosslinkable polymer compound containing a structural unit represented by the following general formula (2) and one or both of structural units represented by the following general formula (4) and the following general formula (4'), 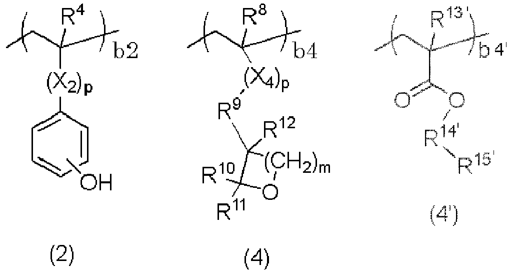 wherein R⁸ represents a hydrogen atom or a methyl group, X₄ each represents -C(=O)-O-, a phenylene group, or a naphthylene group; R⁹ represents a linear, branched, or cyclic alkylene group having 1 to 15 carbon atoms, optionally containing a hydroxy group, an ester group, an ether group, or an aromatic hydrocarbon, R¹⁰ represents a hydrogen atom, a linear, branched, or cyclic alkyl group having 1 to 6 carbon atoms, or is optionally bonded with R⁹ to form a ring; R¹¹ represents a hydrogen atom or a linear, branched, or cyclic alkyl group having 1 to 6 carbon atoms, R¹² represents a hydrogen atom or a linear alkyl group having 1 to 6 carbon atoms, and is optionally bonded with R⁹ to form a ring; "m" is 0 or 1; "p" is 0 or 1; R^{13'} represents a hydrogen atom or a methyl group, R^{14'} represents a single bond or an alkylene group, R^{15'} represents a blocked isocyanate group; 0 < b2 < 1.0, 0 ≤ b4 < 1.0, 0 ≤ b4' < 1.0, 0 < b4 + b4' < 1.0, 0 < b2 + b4 + b4' ≤ 1.0, or 0 < b2 + b4 ≤ 1.0 and 0 < b2 + b4' ≤ 1.0; R⁴ represents a hydrogen atom or a methyl group, X₂ each represents - C(=O)-O-, -C(=O)-NH-, or -C(=O)-N(R⁵OH)-; and R⁵ represents a divalent linear, branched, or cyclic aliphatic saturated hydrocarbon group having 1 to 12 carbon atoms, or an aromatic hydrocarbon group having 6 to 12 carbon atoms, wherein a carbon atom of the aliphatic saturated hydrocarbon group is optionally substituted with an oxygen atom.

Furthermore, the component (B) is more preferably a crosslinkable polymer compound containing a structural unit represented by the following general formula (2), a structural unit represented by the following general formula (5), and one or both of structural units represented by the following general formula (4) and the following general formula (4'), 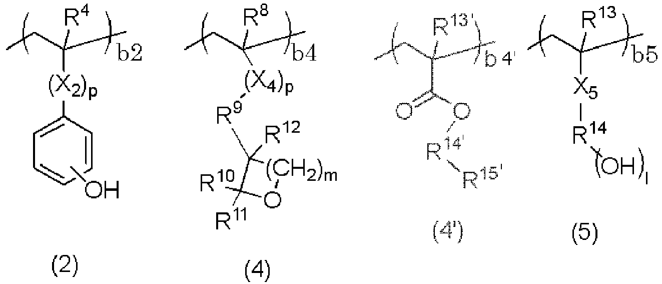 wherein R¹³ represents a hydrogen atom or a methyl group, R¹⁴ represents a linear, branched, or cyclic aliphatic saturated hydrocarbon group with a valency of (1+1) having 1 to 12 carbon atoms, wherein a carbon atom of the aliphatic saturated hydrocarbon group is optionally substituted with an oxygen atom; X₅ each represents - C(=O)-O-, -C(=O)-NH-, -C(=O)-N(R¹⁵OH)-, a phenylene group, or a naphthylene group; R¹⁵ represents a divalent linear, branched, or cyclic aliphatic saturated hydrocarbon group having 1 to 12 carbon atoms, or an aromatic hydrocarbon group having 6 to 12 carbon atoms, wherein a carbon atom of the aliphatic saturated hydrocarbon group is optionally substituted with an oxygen atom; "l" is 0 or 1; 0 < b2 < 1.0, 0 ≤ b4 < 1.0, 0 ≤ b4' < 1.0, 0 < b4 + b4' < 1.0, 0 ≤ b5 < 1.0, 0 < b2 + b4 + b4' + b5 ≤ 1.0, or 0 < b2 + b4 + b5 ≤ 1.0 and 0 < b2 + b4' + b5 ≤ 1.0; R⁴ represents a hydrogen atom or a methyl group, X₂ each represents -C(=O)-O-, -C(=O)-NH-, or -C(=O)-N(R⁵OH)-; R⁵ represents a divalent linear, branched, or cyclic aliphatic saturated hydrocarbon group having 1 to 12 carbon atoms, or an aromatic hydrocarbon group having 6 to 12 carbon atoms, wherein a carbon atom of the aliphatic saturated hydrocarbon group is optionally substituted with an oxygen atom; "p" is 0 or 1; R⁸ represents a hydrogen atom or a methyl group, X₄ each represents -C(=O)-O-, a phenylene group, or a naphthylene group; R⁹ represents a linear, branched, or cyclic alkylene group having 1 to 15 carbon atoms, optionally containing a hydroxy group, an ester group, an ether group, or an aromatic hydrocarbon, R¹⁰ represents a hydrogen atom, a linear, branched, or cyclic alkyl group having 1 to 6 carbon atoms, or is optionally bonded with R⁹ to form a ring; R¹¹ represents a hydrogen atom or a linear, branched, or cyclic alkyl group having 1 to 6 carbon atoms, R¹² represents a hydrogen atom or a linear alkyl group having 1 to 6 carbon atoms, and is optionally bonded with R⁹ to form a ring; "m" is 0 or 1; R^{13'} represents a hydrogen atom or a methyl group, R^{14'} represents a single bond or an alkylene group, and R^{15'} represents a blocked isocyanate group.

When such a crosslinkable polymer compound is added to (A) an alkali-soluble resin containing at least one or more structures selected from a polyimide structure, a polybenzoxazole structure, a polyamide-imide structure, and a precursor structure thereof, sufficient alkali-solubility can be sustained, and a pattern with favorable rectangularity can be obtained. Moreover, since a crosslinkable group excellent in crosslinking property is present, the compound undergoes a crosslinking reaction with a phenolic hydroxy group of (A) the alkali-soluble resin, so that there is no degradation in adhesiveness with a substrate after a reliability test.

Furthermore, the component (D) preferably contains one or more kinds of crosslinking agents selected from an amino condensate modified by formaldehyde or formaldehyde-alcohol; and a phenol compound having two or more methylol groups or alkoxymethylol groups by average in one molecule.

Such a component (D) allows suitable alkali-solubility of the photosensitive resin composition, and sufficient crosslinking reaction progresses at a PEB (Post Exposure Bake) temperature in patterning by lithography, so that excellent patterning by lithography becomes possible.

Preferably, 10 to 100 parts by mass of the component (B) are contained relative to 100 parts by mass of the component (A).

Within such a range, sufficient mechanical characteristics, in particular, elongation and tensile strength of the cured film can be achieved while maintaining lithography characteristics.

The present invention preferably further comprises one or more out of (E) a basic compound, (F) a thermal acid generator, (G) an antioxidant, and (H) a silane compound.

When the component (E) is contained, not only can dissolution contrast in lithography patterning be enhanced, the pattern shape can also be controlled. The component (F) can further improve the mechanical strength, chemical resistance, adhesiveness and so forth of an obtained pattern or film by further advancing the crosslinking and curing reaction. The component (G) can suppress degradation of physical properties due to degradation by oxidation of the cured film during a reliability test such as a high humidity test or a thermal shock test, and a more suitable cured film can be formed. The component (H) can further improve the adhesiveness of the obtained pattern or film to a substrate.

Furthermore, the present invention provides a patterning process comprising:
(1) forming a photosensitive material film by coating a substrate with the above-described negative photosensitive resin composition;
(2) subsequently, after a heat treatment, exposing the photosensitive material film with a high energy beam having a wavelength of 190 to 500 nm or an electron beam via a photomask; and
(3) after irradiation, developing the substrate, which has been heat-treated, with a developer of an alkaline aqueous solution.

According to such a patterning process, since the negative photosensitive resin composition used is soluble in an alkaline aqueous solution, a fine pattern can be formed and high resolution can be achieved.

Furthermore, the present invention provides a method for forming a cured film comprising:
heating and post-curing a film on which a pattern is formed by the above-described patterning process at a temperature of 100 to 300°C.

According to such a method for forming a cured film, a cured film (pattern) excellent in mechanical characteristics can be formed even when cured at low temperatures.

Furthermore, the present invention provides an interlayer insulation film, being a cured film by curing the above-described negative photosensitive resin composition.

Furthermore, the present invention provides a surface protective film, being a cured film by curing the above-described negative photosensitive resin composition.

The cured film obtained by curing the inventive negative photosensitive resin composition has excellent adhesiveness with a substrate, heat resistance, electric characteristics, mechanical strength, and chemical resistance to alkaline release liquid or the like, and a semiconductor device having the cured film as a protective coating has excellent reliability. Therefore, the cured film is suitable as a protective coating (an interlayer insulation film or surface protective film) of electric and electronic components, semiconductor devices and the like.

Furthermore, the present invention provides an electronic component having the above-described interlayer insulation film or surface protective film.

Such a protective coating (interlayer insulation film or surface protective film) is effective for an insulation film for semiconductor devices including rewiring use, an insulation film for multilayer printed board and so on from the viewpoint of heat resistance, chemical resistance, and insulation property, and can give electronic components having excellent reliability.

### ADVANTAGEOUS EFFECTS OF INVENTION

As described above, according to the present invention, it is possible to provide a negative photosensitive resin composition that is soluble in an alkaline aqueous solution, makes it possible to form a fine pattern with high rectangularity and achieve high resolution, and has excellent mechanical characteristics and adhesiveness to a substrate even when cured at low temperatures.

### BRIEF DESCRIPTION OF DRAWINGS

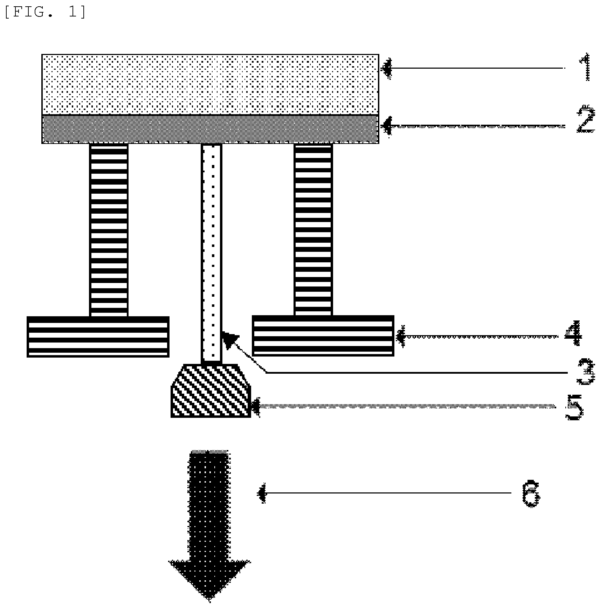

FIG. 1 is an explanatory diagram illustrating an adhesive force measurement method.

### DESCRIPTION OF EMBODIMENTS

As described above, there has been demand for a photosensitive resin composition that is soluble in an alkaline aqueous solution, makes it possible to form a fine pattern with high rectangularity and achieve high resolution, and has excellent mechanical characteristics and adhesiveness to a substrate even when cured at low temperatures.

To achieve the object, the present inventors have earnestly studied and found out that a pattern obtained by using a negative photosensitive resin composition containing: (A) an alkali-soluble resin containing at least one or more structures selected from a polyimide structure, a polyamide structure, a polybenzoxazole structure, a polyamide-imide structure, and a precursor structure thereof; (B) a crosslinkable polymer compound containing a structural unit represented by the following general formula (1) and having a group crosslinked with the component (A); (C) a compound that generates an acid by light; and (D) a crosslinking agent is fine and has a rectangular pattern shape. The present inventors have also found out that the mechanical characteristics and adhesiveness of the obtained cured film to a substrate are excellent. 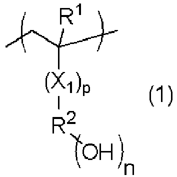 In the formula, R¹ represents a hydrogen atom or a methyl group, R² represents a linear, branched, or cyclic aliphatic saturated hydrocarbon group with a valency of (n+1) having 1 to 15 carbon atoms, an aromatic hydrocarbon group having 6 to 15 carbon atoms, a benzyl group, or a naphthalene methyl group, where a carbon atom of the aliphatic saturated hydrocarbon group is optionally substituted with an oxygen atom; "n" is an integer of 1 to 5; X₁ each represents -C(=O)-O-, -C(=O)-NH-, or -C(=O)-N(R³OH)-; R³ represents a divalent linear, branched, or cyclic aliphatic saturated hydrocarbon group having 1 to 12 carbon atoms, or an aromatic hydrocarbon group having 6 to 12 carbon atoms, where a carbon atom of the aliphatic saturated hydrocarbon group is optionally substituted with an oxygen atom; and "p" is 0 or 1.

Furthermore, the present inventors have found out that a protective film obtained by using the above-described negative photosensitive resin composition by forming a pattern and heating has excellent mechanical characteristics, and has excellent adhesion after a high temperature and high humidity test. That is, the present inventors have found out that a cured film with a pattern formed by using the negative photosensitive resin composition is excellent as an electric and electronic component protective film, and an insulation protective film, and thus completed the present invention. In the present specification, the electric and electronic components are also summarized as "electronic component".

That is, the present invention provides a negative photosensitive resin composition containing:
(A) an alkali-soluble resin containing at least one or more structures selected from a polyimide structure, a polyamide structure, a polybenzoxazole structure, a polyamide-imide structure, and a precursor structure thereof;
(B) a crosslinkable polymer compound containing a structural unit represented by the general formula (1) and having a group crosslinked with the component (A);
(C) a compound that generates an acid by light; and
(D) a crosslinking agent other than the component (B).

Hereinafter, the present invention will be described in detail, but the present invention is not limited thereto.

### [Negative Photosensitive Resin Composition]

The negative photosensitive resin composition of the present invention will be described.

The inventive negative photosensitive resin composition contains:
(A) an alkali-soluble resin containing at least one or more structures selected from a polyimide structure, a polyamide structure, a polybenzoxazole structure, a polyamide-imide structure, and a precursor structure thereof;
(B) a crosslinkable polymer compound containing a structural unit represented by the following general formula (1) and having a group crosslinked with the component (A);
(C) a compound that generates an acid by light; and
(D) a crosslinking agent other than the component (B).

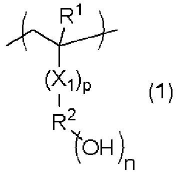

In the formula, R¹ represents a hydrogen atom or a methyl group, R² represents a linear, branched, or cyclic aliphatic saturated hydrocarbon group with a valency of (n+1) having 1 to 15 carbon atoms, an aromatic hydrocarbon group having 6 to 15 carbon atoms, a benzyl group, or a naphthalene methyl group, where a carbon atom of the aliphatic saturated hydrocarbon group is optionally substituted with an oxygen atom; "n" is an integer of 1 to 5; X₁ each represents -C(=O)-O-, -C(=O)-NH-, or -C(=O)-N(R³OH)-; R³ represents a divalent linear, branched, or cyclic aliphatic saturated hydrocarbon group having 1 to 12 carbon atoms, or an aromatic hydrocarbon group having 6 to 12 carbon atoms, where a carbon atom of the aliphatic saturated hydrocarbon group is optionally substituted with an oxygen atom; and "p" is 0 or 1.

The negative photosensitive resin composition can be alkali-developed. Furthermore, the negative photosensitive resin composition may further contain, as needs arise, (E) a basic compound, (F) a thermal acid generator, (G) an antioxidant, (H) a silane compound, and the like, besides the component (A), component (B), component (C), and component (D). Hereinafter, these components will be described in detail.

### [(A) Alkali-Soluble Resin]

The alkali-soluble resin (A) of the present invention contains at least one or more structures selected from a polyimide structure, a polyamide structure, a polybenzoxazole structure, a polyamide-imide structure, and a precursor structure thereof. The resin (A) is not particularly limited as long as the resin (A) is an alkali-soluble resin containing a structure mentioned above, but a resin containing the structure represented by the following general formula (6) and/or (7) is preferable.

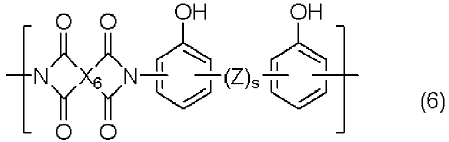

In the formula, X₆ represents a tetravalent organic group, "s" represents 0 or 1, Z represents a divalent linking group, and when "s" is 0, two aromatic rings in the formula are directly bonded without a linking group. 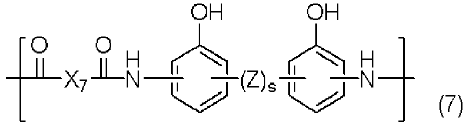 In the formula, X₇ represents a divalent organic group, and "s" and Z are the same as those described above.

X₆ in the general formula (6) represents a tetravalent organic group, but is not limited as long as it is a tetravalent organic group. X₆ is preferably a tetravalent organic group of an alicyclic aliphatic group having 4 to 40 carbon atoms or an aromatic group, and more preferably, a tetravalent organic group represented by the following formula (8). Furthermore, a structure of X₆ may be one kind or a combination of two or more kinds. 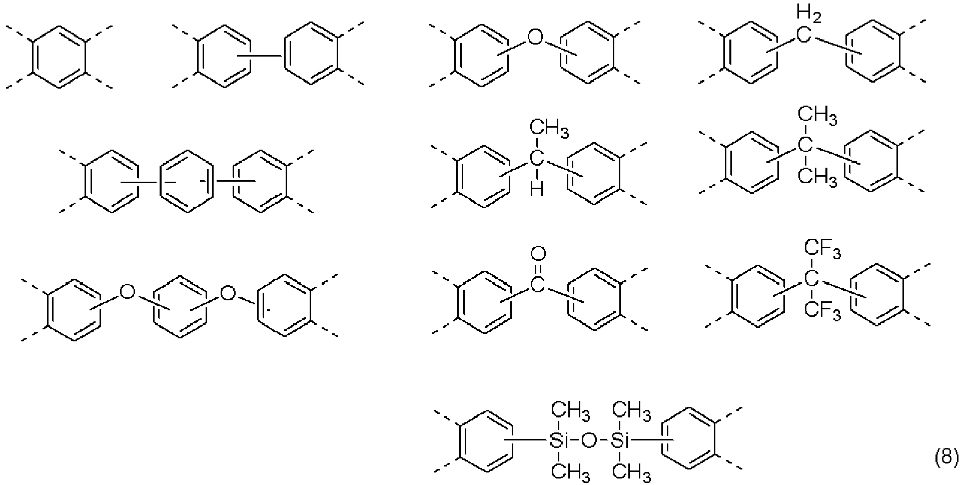 In the formulae, a dotted line represents a bond.

The "s" in the general formula (6) represents 0 or 1, and when "s" is 0, two aromatic rings in the general formula (6) are bonded directly without the divalent linking group Z.

Meanwhile, when "s" is 1, two aromatic rings in the general formula (6) are bonded via the divalent linking group Z. Z is not limited as long as it is a divalent group. Preferably, Z is a divalent organic group of an alicyclic aliphatic group having 4 to 40 carbon atoms or an aromatic group, and more preferably a divalent linking group represented by the following formula (9). The structure of Z may be one kind or a combination of two or more kinds. 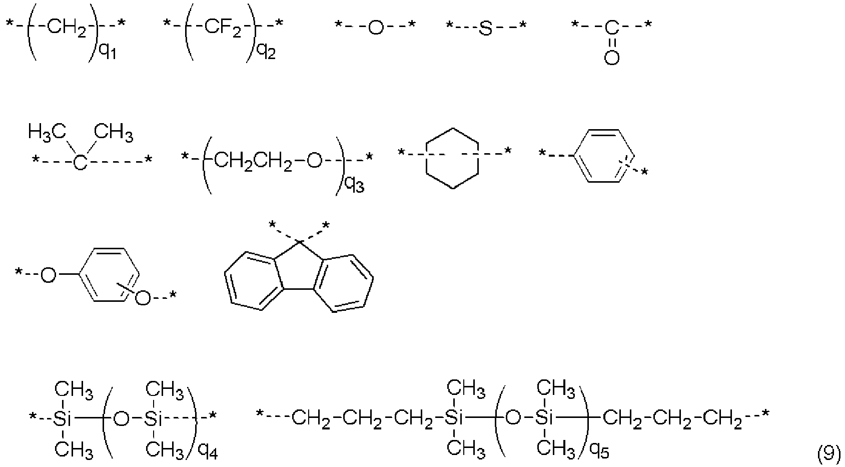 In the formulae, q₁, q₂, and q₃ represent an integer of 1 to 6, and q₄ and q₅ represent an integer of 1 to 10. A dotted line represents a bond.

In particular, a preferable divalent linking group Z is a divalent group represented by the following general formula (10) or (11). 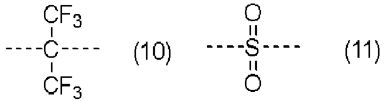 In the formulae, a dotted line represents a bond.

As a structural unit represented by the general formula (6), when Z in the general formula (6) is a group represented by the formula (10), a structural unit represented by the following general formula (6-1) is preferable, and when Z in the general formula (6) is a group represented by the formula (11), a structural unit represented by the following general formula (6-2) is preferable. 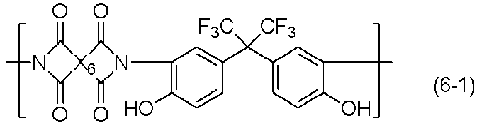 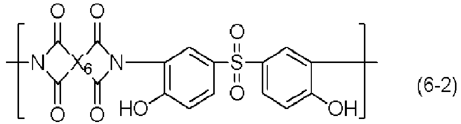 In the formulae, X₆ is the same as that described above.

As shown by the general formula (6-1), when the divalent linking group Z is a hexafluoropropylene group shown by the formula (10) and is located at a p-position of a phenolic hydroxy group, the acidity of the phenolic hydroxy group becomes high since the hexafluoropropylene group is an electron-withdrawing group. Thus, the solubility of an alkaline aqueous solution to a developer increases. Therefore, it is preferred that the Z be the group shown by the formula (10).

Similarly, as shown by the general formula (6-2), when the divalent linking group Z is a sulfonic group represented by the formula (11) and is located at a p-position of a phenolic hydroxy group, the acidity of the phenolic hydroxy group becomes high since the sulfonic group is also an electron-withdrawing group. Thus, the solubility of an alkaline aqueous solution to a developer increases. Therefore, it is also preferred that the Z be the group shown by the formula (11).

The X₇ in the general formula (7) is a divalent organic group, and is not limited as long as it is a divalent organic group. Preferably, X₇ is a divalent organic group of an aliphatic chain length structure or an alicyclic aliphatic group having 4 to 40 carbon atoms, or an aromatic group. Further preferably, X₇ is a divalent organic group represented by the following formula (12). The structure of X₇ may be one kind or a combination of two or more kinds.

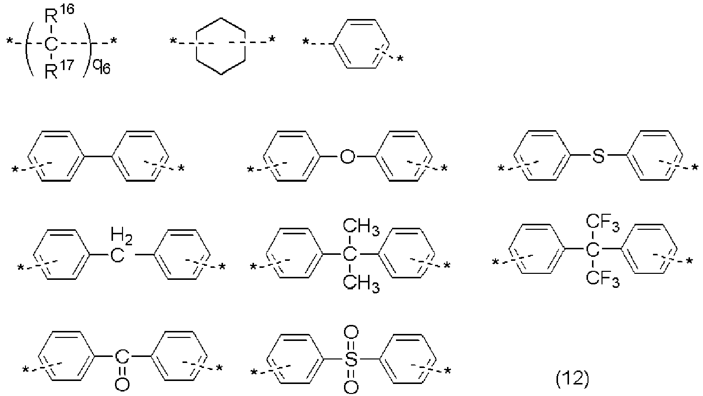

In the formulae, R¹⁶ and R¹⁷ each independently represents a hydrogen atom, a fluorine atom, or an alkyl group having 1 to 6 carbon atoms, q₆ is an integer of 1 to 30, and a dotted line represents a bond.

When the X₇ in the general formula (7) is a divalent organic group that is an aliphatic chain length structure, the mechanical strength, in particular, the elongation of a cured film of the inventive negative photosensitive resin composition is improved. Therefore, this case is preferred.

The "s" and Z in the general formula (7) are the same as the above, and Z is preferably the general formula (10) or (11) from the viewpoint of the solubility to a developer of an alkaline aqueous solution. Also in this case, in the same manner as the case of the formulae (6-1) and (6-2), the acidity of the phenolic hydroxy group becomes higher, and the solubility to the developer that is an alkaline aqueous solution is improved. Therefore, this case is preferred.

The alkali-soluble resin (A) of the present invention may further contain a structural unit represented by the following general formula (13) (hereinafter, also referred to as a structural unit (13)), in addition to the structural units shown by the general formulae (6) and (7). 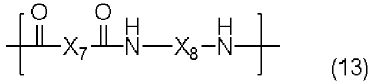 In the formula, X₇ is the same as the above. X₈ is a divalent organic group.

The X₈ in the general formula (13) is a divalent organic group, and is not restricted as long as it is a divalent organic group. However, Xs is preferably a divalent organic group having 6 to 40 carbon atoms, more preferably a cyclic organic group having an aromatic ring having a substituent or a cyclic organic group containing 1 to 4 aliphatic rings, or an aliphatic group or a siloxane group not having a cyclic structure. Further suitable examples of X₈ include structures shown by the following formulae (14) or (15). The structure of X₈ may be one kind or a combination of two or more kinds. 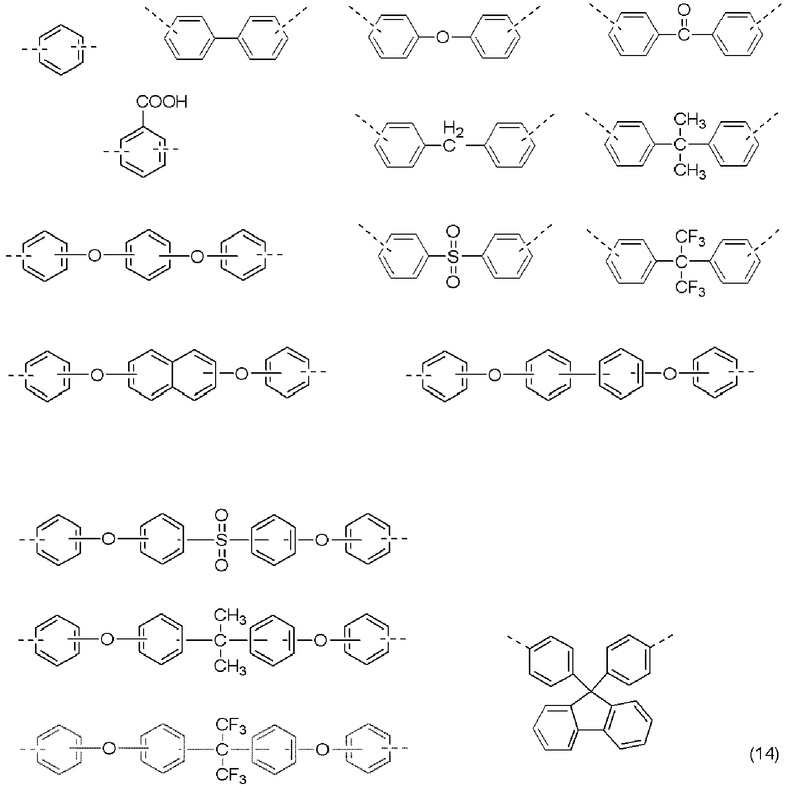 In the formulae, a dotted line represents a bond with an amino group. 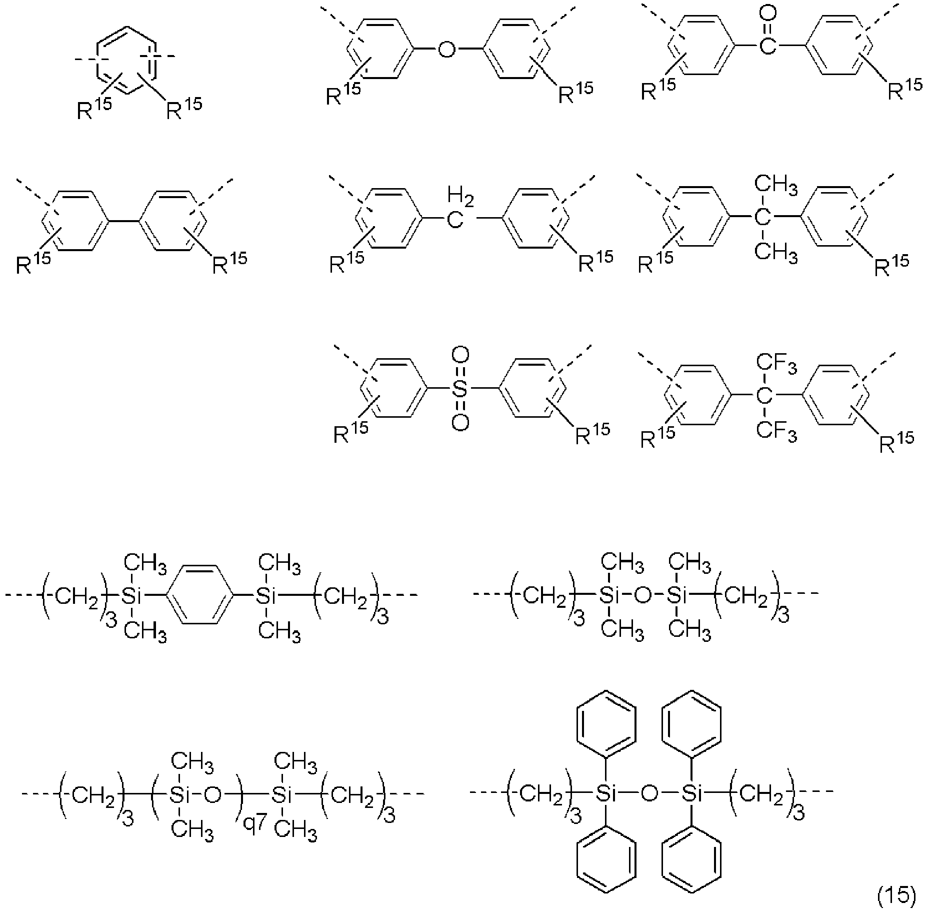 In the formulae, a dotted line represents a bond with an amino group, R¹⁵ each independently represents a methyl group, an ethyl group, a propyl group, an n-butyl group, or a trifluoromethyl group, and q₇ represents a positive number of 2 to 20.

The alkali-soluble resin (A) of the present invention preferably further contains a structural unit represented by the following general formula (16) (hereinafter, also referred to as a structural unit (16)) in addition to the structural units represented by the general formulae (6) and (7). 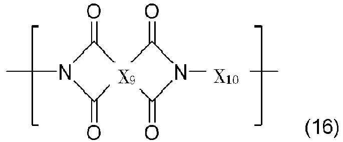 In the formula, X₉ is the same tetravalent organic group as or different from the X₆, and X₁₀ is a group represented by the following general formula (17).

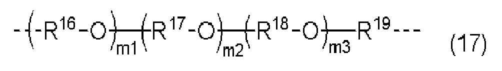

In the formula, R¹⁶ to R¹⁹ each independently represent a linear or branched alkylene group having 2 to 10 carbon atoms, m₁ is an integer of 1 to 40, and m₂ and m₃ each independently represent an integer of 0 to 40.

X₉ in the formula (16) may be a tetravalent organic group cited as X₆, for example, a tetravalent organic group shown by the formula (8). Meanwhile, in X₁₀ (the group represented by the general formula (17)), specific examples of a preferred organic group include the following. However, there is no restriction to these.

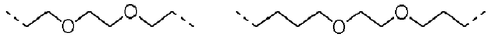

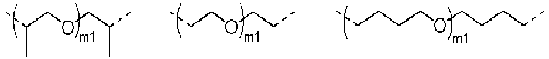

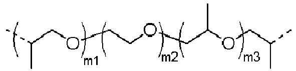

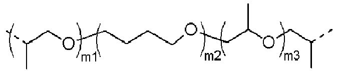

When the alkali-soluble resin (A) contains such a structural unit (16), flexibility is produced to obtain a cured film having high elongation and low warpage.

Furthermore, the alkali-soluble resin (A) of the present invention can also contain a structural unit represented by the following general formula (18) or (19) (hereinafter, structural unit (18), structural unit (19)).

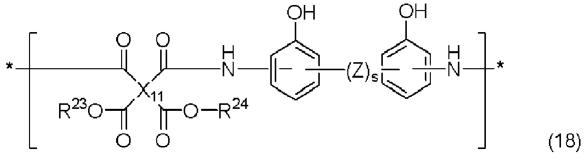

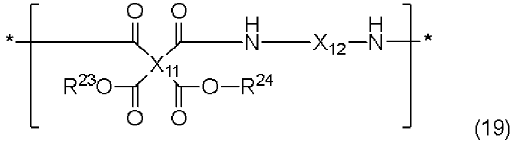

In the formulae, X₁₁ is the same tetravalent organic group as or different from the above X₆, X₁₂ is the same divalent organic group as or different from X₈, and "s" and Z are the same as above. R²³ and R²⁴ are each independently a hydrogen atom, a linear, branched, or cyclic alkyl group having 1 to 6 carbon atoms, or an organic group represented by the following general formula (20), where at least one of R²³ and R²⁴ is an organic group represented by the following general formula (20).

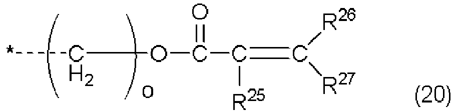

In the formula, a dotted line represents a bond. R²⁵ is a hydrogen atom or an organic group having 1 to 3 carbon atoms, R²⁶ and R²⁷ are each independently a hydrogen atom or an organic group having 1 to 3 carbon atoms, and "o" is an integer of 2 to 10.

The X₁₁ in the structural units (18) and (19) is a tetravalent organic group and can be the same as or different from the above-described X₆, and is not limited as long as it is a tetravalent organic group. X₁₁ is preferably a tetravalent organic group of an alicyclic aliphatic group having 4 to 40 carbon atoms or an aromatic group, further preferably a tetravalent organic group represented by the formula (8). The structure of X₁₁ may be one kind or a combination of two or more kinds.

Meanwhile, the X₁₂ in the structural unit (19) is a divalent organic group and can be the same as or different from the above-described X₈, and is not limited as long as it is a divalent organic group. X₁₂ is preferably a divalent organic group having 6 to 40 carbon atoms, more preferably a cyclic organic group having an aromatic ring having a substituent or a cyclic organic group containing 1 to 4 aliphatic rings, or an aliphatic group or a siloxane group not having a cyclic structure. Further suitable examples of X₁₂ include structures shown by the formulae (14) or (15). The structure of X₁₂ may be one kind or a combination of two or more kinds.

The R²³ and R²⁴ in the structures (18) and (19) are each independently a hydrogen atom or a linear, branched, or cyclic alkyl group having 1 to 6 carbon atoms, or an organic group represented by the general formula (20), and at least one of R²³ and R²⁴ is an organic group represented by the general formula (20).

The R²⁵ in the general formula (20) is not limited as long as it is a hydrogen atom or a monovalent organic group having 1 to 3 carbon atoms. However, from the viewpoint of photosensitive characteristics of the negative photosensitive resin composition, a hydrogen atom or a methyl group is preferable.

The R²⁶ and R²⁷ in the general formula (20) are not limited as long as they are each independently a hydrogen atom or a monovalent organic group having 1 to 3 carbon atoms. However, from the viewpoint of photosensitive characteristics of the negative photosensitive resin composition, a hydrogen atom is preferable.

The "o" in the general formula (20) is an integer of 2 to 10, and from the viewpoint of photosensitive characteristics, is preferably an integer of 2 to 4. Further preferably, "o" is 2.

### [(B) Crosslinkable Polymer Compound]

The crosslinkable polymer compound (B) used in the present invention is not particularly limited as long as it contains a structural unit represented by the following general formula (1), and has a group crosslinked with the component (A).

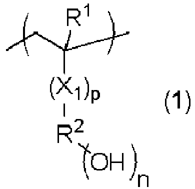

Here, in the general formula (1), R¹ represents a hydrogen atom or a methyl group. R² represents a linear, branched, or cyclic aliphatic saturated hydrocarbon group with a valency of (n+1) having 1 to 15 carbon atoms, an aromatic hydrocarbon group having 6 to 15 carbon atoms, a benzyl group, or a naphthalene methyl group, where a carbon atom of the aliphatic saturated hydrocarbon group is optionally substituted with an oxygen atom. "n" is an integer of 1 to 5. X₁ each represents -C(=O)-O-, -C(=O) -NH-, or -C(=O)-N(R³OH)-. R³ represents a divalent linear, branched, or cyclic aliphatic saturated hydrocarbon group having 1 to 12 carbon atoms, or an aromatic hydrocarbon group having 6 to 12 carbon atoms, where a carbon atom of the aliphatic saturated hydrocarbon group is optionally substituted with an oxygen atom. "p" is 0 or 1.

In addition, specific examples of a monomer that can be favorably used for obtaining the structure represented by the general formula (1) include the following. 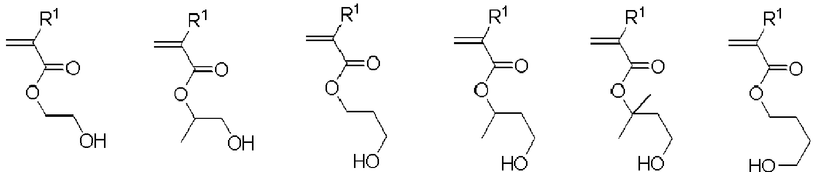 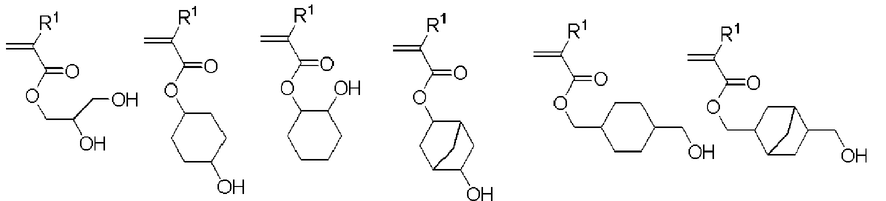 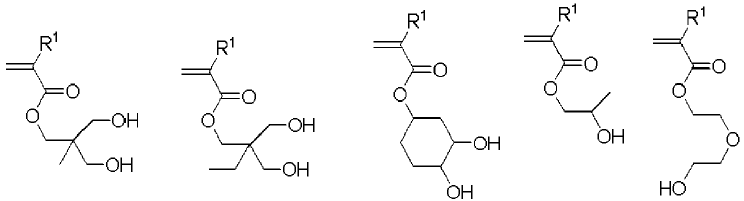 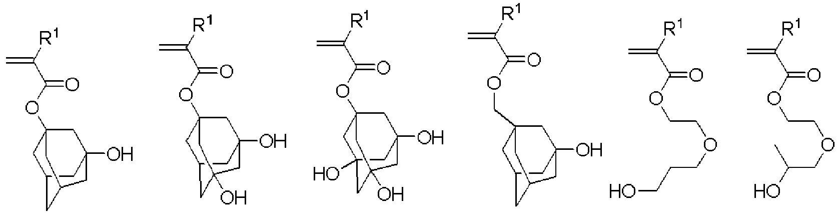 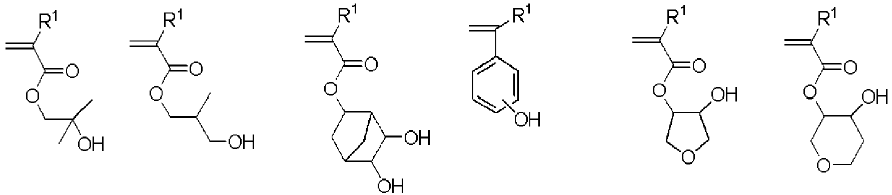 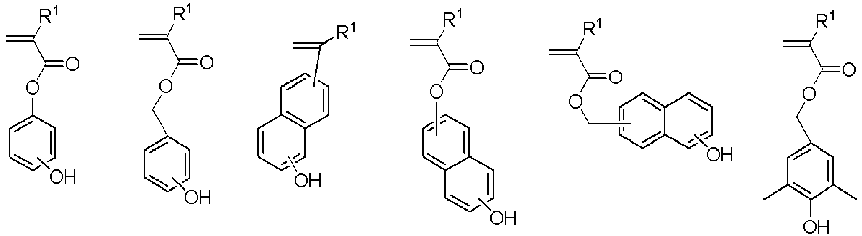 In the formulae, R¹ is as described above. 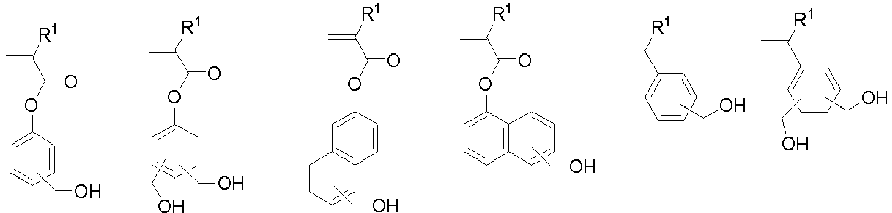 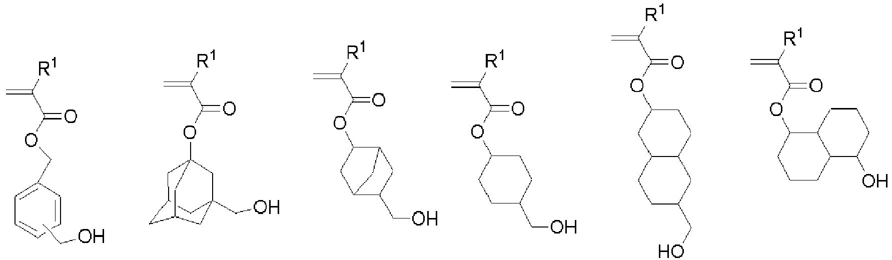 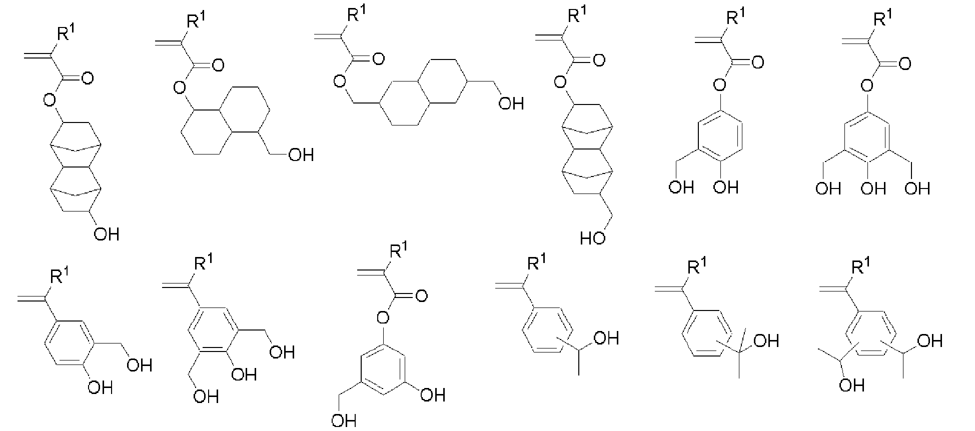 In the formulae, R¹ is as described above. 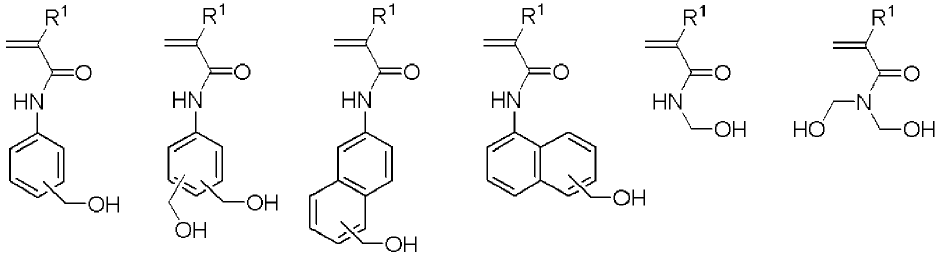 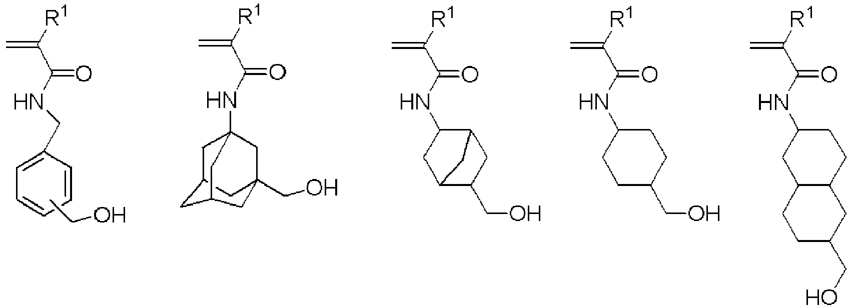 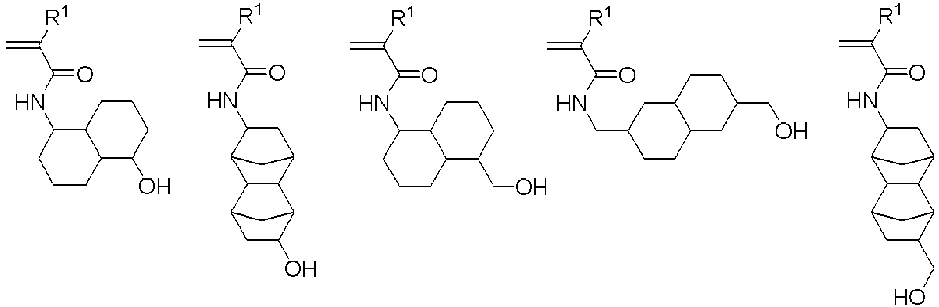 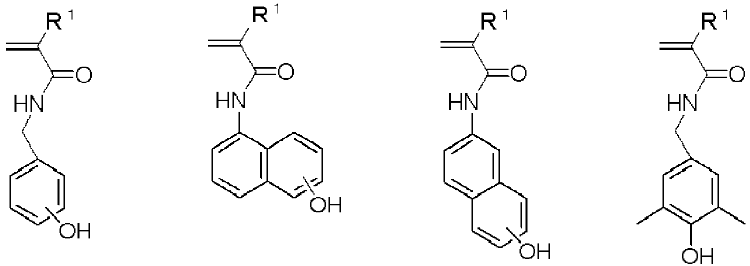 In the formulae, R¹ is as described above.

The group to be crosslinked with the component (A) alkali-soluble resin is not particularly limited. Examples thereof include an oxazoline group, an isocyanate group, a blocked isocyanate group, an oxetanyl group, and an epoxy group described below.

Furthermore, the component (B) more preferably contains structural units represented by the following general formula (2) and the following general formula (3), so that crosslinking density can be improved while maintaining alkali-solubility.

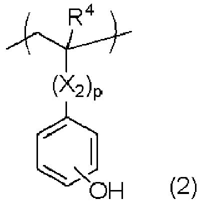

Here, in the general formula (2), R⁴ represents a hydrogen atom or a methyl group. X₂ each represents - C(=O)-O-, -C(=O) -NH-, or -C(=O)-N(R⁵OH)-. R⁵ represents a divalent linear, branched, or cyclic aliphatic saturated hydrocarbon group having 1 to 12 carbon atoms, or an aromatic hydrocarbon group having 6 to 12 carbon atoms, where a carbon atom of the aliphatic saturated hydrocarbon group is optionally substituted with an oxygen atom. "p" is 0 or 1.

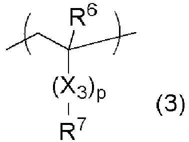

Here, in the general formula (3), R⁶ represents a hydrogen atom or a methyl group. R⁷ represents a group containing an oxazoline group, an isocyanate group, a blocked isocyanate group, an oxetanyl group, and an epoxy group. X₃ represents -C(=O)-O-, a phenylene group, or a naphthylene group. "p" is 0 or 1.

In particular, when the structure represented by the general formula (2) has a carbonyl group or an amide group, being electron-withdrawing groups, on a p-position of a phenolic hydroxy group, the acidity of the phenolic hydroxy group becomes high. Thus, solubility to a developer of an alkaline aqueous solution becomes improved. Specific examples of monomers that can be favorably used for forming the structural unit of the general formula (2) include the following. However, examples are not limited thereto. 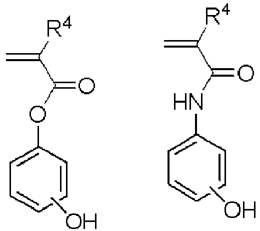 In the formulae, R⁴ is as described above.

The general formula (2) is effective as a unit for promoting crosslinking in addition to alkali-solubility, and curability can be further improved by using together with a crosslinkable group.

Furthermore, to improve crosslinking density, a monomer having an epoxy group or an oxetanyl group shown by the following general formula (4), or a monomer having a blocked isocyanate group shown by the following general formula (4') is preferably copolymerized.

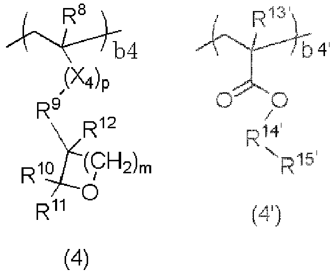

Here, in the general formula (4), R⁸ represents a hydrogen atom or a methyl group. X₄ each represents - C(=O)-O-, a phenylene group, or a naphthylene group. R⁹ represents a linear, branched, or cyclic alkylene group having 1 to 15 carbon atoms, optionally containing an ester group, an ether group, or an aromatic hydrocarbon. R¹⁰ represents a hydrogen atom, a linear, branched, or cyclic alkyl group having 1 to 6 carbon atoms, or is optionally bonded with R⁹ to form a ring. R¹¹ represents a hydrogen atom or a linear, branched, or cyclic alkyl group having 1 to 6 carbon atoms. R¹² represents a hydrogen atom or a linear alkyl group having 1 to 6 carbon atoms. "m" is 0 or 1. "p" is 0 or 1. Examples of the unit of the formula (4) include the following. 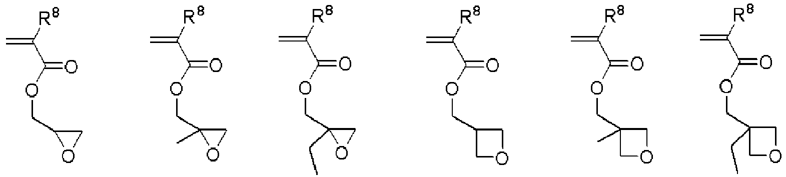 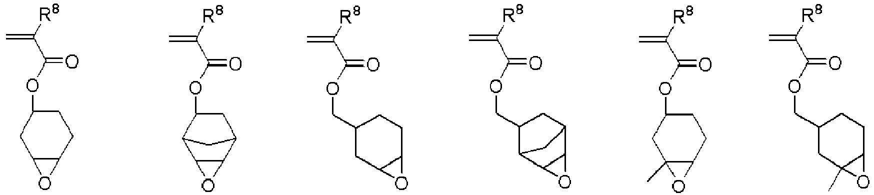 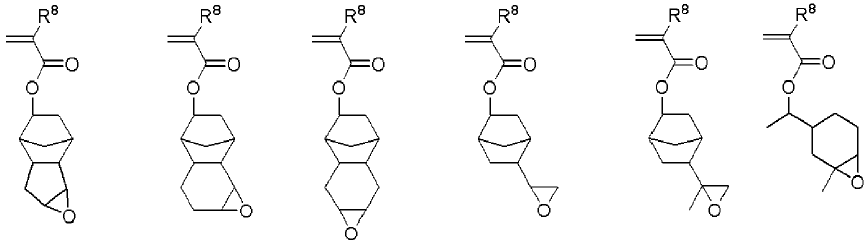 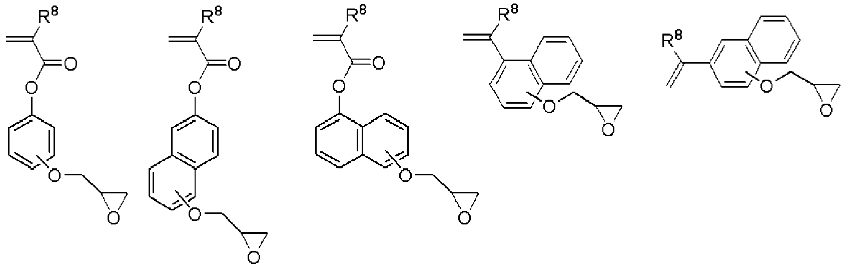 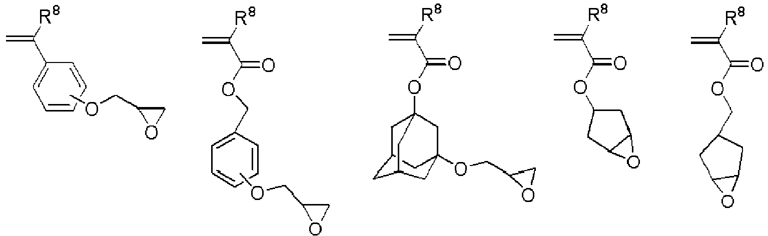 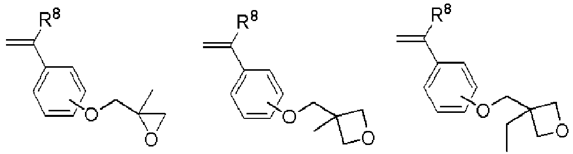 In the formulae, R⁸ is as described above. 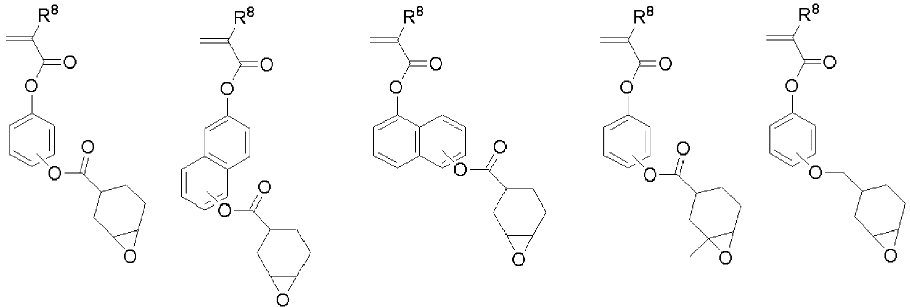 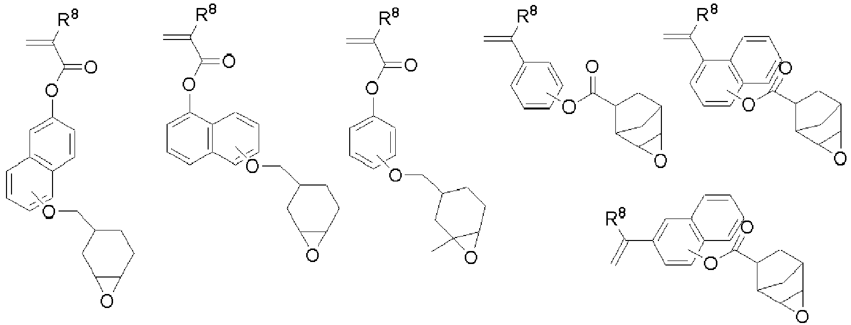 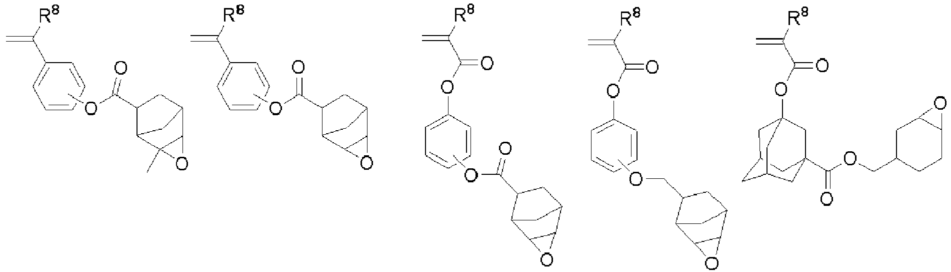 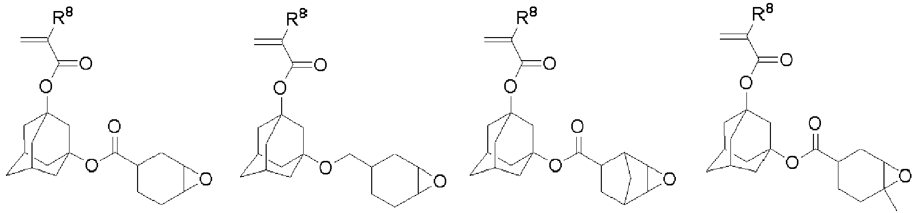 In the formulae, R⁸ is as described above. 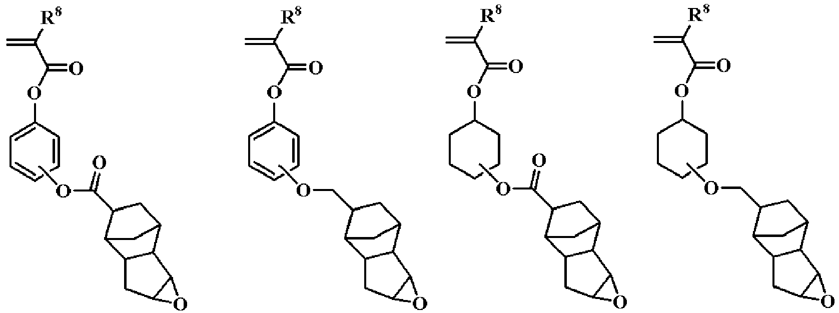 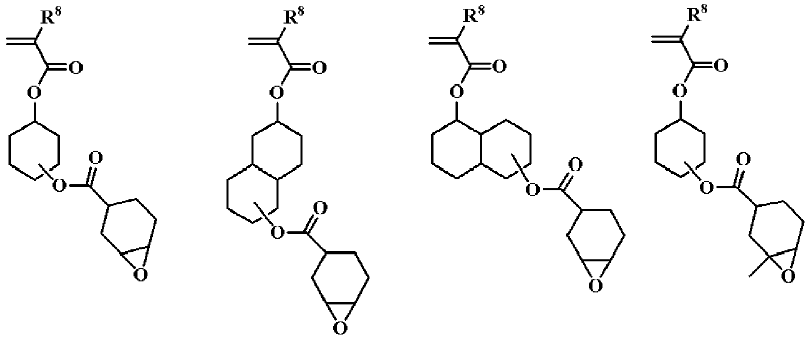 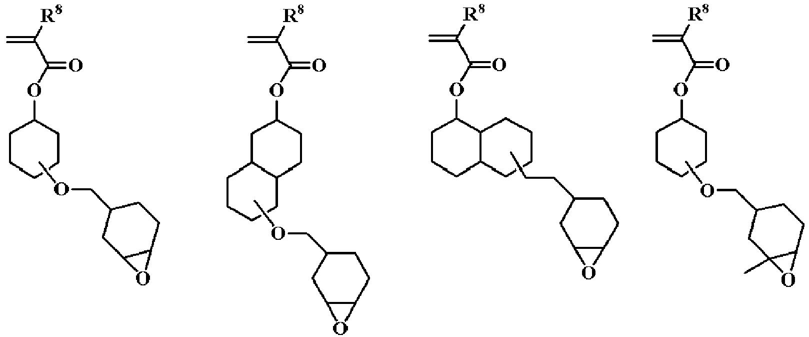 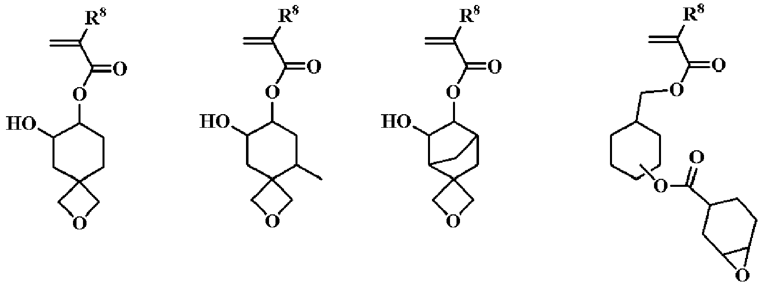 In the formulae, R⁸ is as described above.

Incidentally, some of the monomers for obtaining a repeating unit having an epoxy group and an oxetanyl group are disclosed in JP 2003-55362 A, JP 2005-8847 A, and JP 2005-18012 A.

Here, in the general formula (4'), R^{13'} represents a hydrogen atom or a methyl group, R^{14'} represents a single bond or an alkylene group, and R^{15'} is a blocked isocyanate group.

The blocked isocyanate group is an organic group having an isocyanate group (-N=C=O) blocked with a suitable protecting group. A blocked isocyanate group can be formed by making an isocyanate group and a blocking agent react.

A blocked isocyanate group is stable at a normal temperature, but at a certain temperature or higher, the blocking agent is eliminated (deblocked), and the hydroxy group or the carboxy group in the component (A) react with the isocyanate group to form a crosslinking structure. Examples of the blocking agent include an active-hydrogen-containing compound that can react with isocyanate, for example, alcohol, phenol, polycyclic phenol, amide, imide, imine, thiol, oxime, lactam, active-hydrogen-containing heterocycle, and activemethylene-containing compound.

Suitable blocked isocyanate groups are disclosed in paragraphs [0015] to [0025] of JP 6601628 B, and those compounds can be used.

In particular, the monomer units shown below are more preferable since these have excellent polymerization property and can be used commercially. In addition, one of these monomers or two or more thereof may be used. 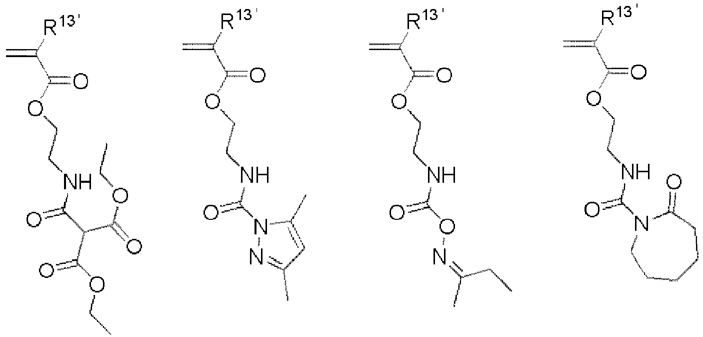 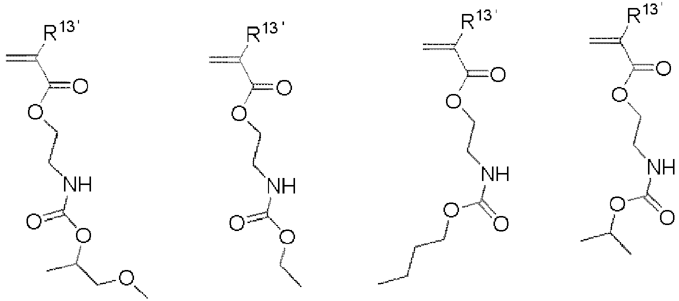 In the formulae, R^{13'} is as described above.

Furthermore, the monomer is preferably not deblocked in a heat treatment after spin-coating of the photosensitive composition (pre-bake) or a heat treatment after exposure (post-exposure bake (PEB)), is deblocked in the post-curing by a heat treatment after development, and undergoes a crosslinking reaction with an alkali-soluble resin.

Therefore, the monomer units shown below, which are deblocked within the range of 140°C to 200°C, are more preferable. 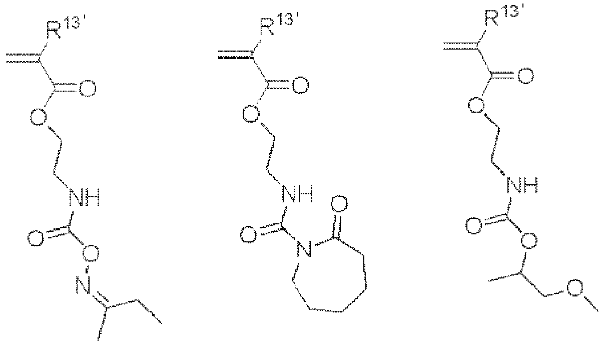 In the formulae, R^{13'} is as described above.

In particular, specific examples that are commercially available include Karenz MOI Series and AOI Series (trade names, manufactured by Showa Denko K.K.).

The structural unit represented by the general formula (2) is excellent in solvent-solubility and alkali-solubility, but does not have crosslinking property. Therefore, it is necessary to copolymerize with the structural unit which has crosslinking property and is represented by the general formula (4) or the general formula (4'). A polymer formed only from epoxy groups and oxetanyl groups represented by the general formula (4) and blocked isocyanate groups represented by the general formula (4') having crosslinking property is excellent in crosslinking property. However, since such a polymer has no alkali-solubility, it is necessary to copolymerize with a structural unit represented by the general formula (2).

Accordingly, when repeating units are copolymerized in this manner, repeating units of the following formulae (1a) are preferably contained. However, regarding structural units having epoxy groups or oxetanyl groups, and structural units having blocked isocyanate groups, having crosslinking property, both or one of these is sufficient.

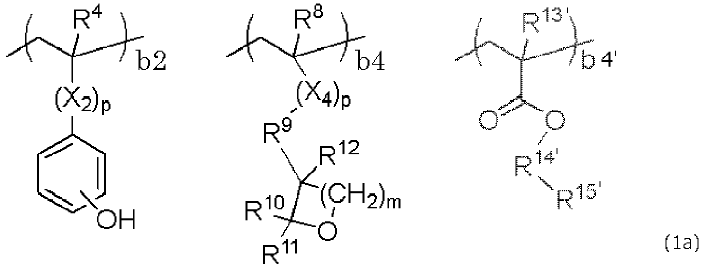

In the formulae, R⁴, R⁸ to R¹², R^{13'} to R^{15'}, X₂, X₄, "m", and "p" are the same as above, and 0 < b2 < 1.0, 0 ≤ b4 < 1.0, 0 ≤ b4' < 1.0, 0 < b4 + b4' < 1.0, 0 < b2 + b4 + b4' ≤ 1.0, or 0 < b2 + b4 ≤ 1.0 and 0 < b2 + b4' ≤ 1.0.

Furthermore, from viewpoints of further improving crosslinking reactivity at the time of lithography patterning and improving the dissolution contrast of the unexposed/exposed part to an alkali developer, a crosslinkable polymer compound containing structural units represented by the following general formula (2), general formula (4), general formula (4'), and general formula (5) is more preferable. However, both or one of the structural units represented by the general formula (4) and the general formula (4') is sufficient.

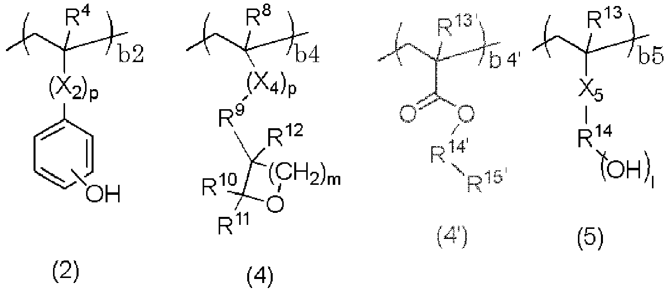

Here, in the general formula (5), R¹³ represents a hydrogen atom or a methyl group, R¹⁴ represents a linear, branched, or cyclic aliphatic saturated hydrocarbon group with a valency of (1+1) having 1 to 12 carbon atoms, where a carbon atom of the aliphatic saturated hydrocarbon group is optionally substituted with an oxygen atom. X₅ each represents -C(=O)-O-, -C(=O)-NH-, -C(=O)-N(R¹⁵OH)-, a phenylene group, or a naphthylene group. R¹⁵ represents a divalent linear, branched, or cyclic aliphatic saturated hydrocarbon group having 1 to 12 carbon atoms, or an aromatic hydrocarbon group having 6 to 12 carbon atoms, where a carbon atom of the aliphatic saturated hydrocarbon group is optionally substituted with an oxygen atom. "l" is 0 or 1. 0 < b2 < 1.0, 0 ≤ b4 < 1.0, 0 ≤ b4' < 1.0, 0 < b4 + b4' < 1.0, 0 ≤ b5 < 1.0, 0 < b2 + b4 + b4' + b5 ≤ 1.0, or 0 < b2 + b4 + b5 ≤ 1.0 and 0 < b2 + b4' + b5 ≤ 1.0. In the general formulae (2), (4), and (4'), R⁴, R⁸ to R¹², R^{13'} to R^{15'}, X₂, X₄, "m", and "p" are the same as above.

The crosslinkable polymer compound of the present invention includes, as a base, a repeating unit with a monomer for obtaining a repeating unit represented by the general formula (1) having a hydroxy group

(hereinafter, noted as b1), and a monomer for obtaining a repeating unit including both or one represented by the general formula (4) and the general formula (4') and that has a group crosslinked with the component (A) alkali-soluble resin (hereinafter, noted as b4 and b4'), for example. It is also possible to copolymerize a monomer b6 for obtaining a repeating unit represented by the following general formula (21) in order to improve adhesiveness to a substrate and flexibility of a cured film, and to further improve mechanical characteristics and thermal shock resistance. 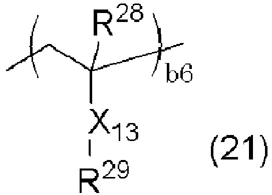 Here, in the general formula (21), R²⁸ represents a hydrogen atom or a methyl group. R²⁹ may have a monovalent organic group having a primary, secondary, or tertiary amino group, an alkyl group having 4 to 20 carbon atoms, an aryl group having 6 to 10 carbon atoms, or an alicyclic group having 6 to 10 carbon atoms. X₁₃ is preferably -C(=O)-O- or -C(=O)-NH-. b6 is 0 ≤ b6 < 1.

Specific examples of monomers for obtaining the repeating unit represented by the general formula (21) include the following: aminoethyl(meth)acrylate, N-methylaminoethyl(meth)acrylate, N,N-dimethylaminoethyl(meth)acrylate, N-ethylaminoethyl(meth)acrylate, N,N-diethylaminoethyl(meth)acrylate, aminopropyl(meth)acrylate, N-methylaminopropyl(meth)acrylate, N,N-dimethylaminopropyl(meth)acrylate, N-ethylaminopropyl(meth)acrylate, N,N-diethylaminopropyl(meth)acrylate, aminoethyl(meth)acrylamide, N-methylaminoethyl(meth)acrylamide, N,N-dimethylaminoethyl(meth)acrylamide, N-ethylaminoethyl(meth)acrylamide, N,N-diethylaminoethyl(meth)acrylamide, aminopropyl(meth)acrylamide, N-methylaminopropyl(meth)acrylamide, N,N-dimethylaminopropyl(meth)acrylamide, N-ethylaminopropyl(meth)acrylamide, N,N-diethylaminopropyl(meth)acrylamide, piperidine-4-yl(meth)acrylate, 1-methylpiperidine-4-yl(meth)acrylate, 2,2,6,6-tetramethylpiperidine-4-yl(meth)acrylate, 1,2,2,6,6-pentamethylpiperidine-4-yl(meth)acrylate, (piperidine-4-yl)methyl(meth)acrylate, 2-(piperidine-4-yl)ethyl(meth)acrylate, piperidine-4-yl(meth)acrylate, 1-methylpiperidine-4-yl(meth)acrylate, 2,2,6,6-tetramethylpiperidine-4-yl(meth)acrylate, 1,2,2,6,6-pentamethylpiperidine-4-yl(meth)acrylate, (piperidine-4-yl)methyl(meth)acrylate, 2-(piperidine-4-yl)ethyl(meth)acrylate, and the like.

Furthermore, a (meth)acrylic acid alkyl ester can be used as a monomer for obtaining the repeating unit represented by the general formula (21), and specific examples include (meth)acrylic acid butyl ester, (meth)acrylic acid pentyl ester, (meth)acrylic acid hexyl ester, (meth)acrylic acid heptyl ester, (meth)acrylic acid octyl ester, (meth)acrylic acid nonyl ester, (meth)acrylic acid decyl ester, (meth)acrylic acid undecyl ester, (meth)acrylic acid dodecyl ester, (meth)acrylic acid tridecyl ester, (meth)acrylic acid tetradecyl ester, (meth)acrylic acid pentadecyl ester, (meth)acrylic acid hexadecyl ester, (meth)acrylic acid heptadecyl ester, (meth)acrylic acid octadecyl ester, (meth)acrylic acid nonadecyl ester, (meth)acrylic acid eicosyl ester, and the like.

Furthermore, in order to improve the mechanical strength of the cured film, it is also possible to copolymerize olefins b7 having an aromatic group such as styrenes, vinylnaphthalenes, vinylanthracenes, vinylcarbazoles, acenaphthylenes, indenes, and the like; and alicyclic olefins b8 such as norbornenes, norbornadienes, and the like.

Regarding the repeating units b2, b4, b4', b5, b6, b7, and b8, the proportion of the repeating units is 0 < b2 < 1.0, 0 ≤ b4 < 1.0, 0 ≤ b4' < 1.0, 0 < b4 + b4' < 1.0, 0 ≤ b5 < 1.0, 0 ≤ b6 ≤ 0.8, 0 ≤ b7 ≤ 0.8, 0 ≤ b8 ≤ 0.8, 0 < b2 + b4 + b4' ≤ 1.0, and 0 < b2 + b4 ≤ 1.0, or 0 < b2 + b4' ≤ 1.0. Preferably, 0 < b2 ≤ 0.5, 0 ≤ b4 ≤ 0.9, 0 ≤ b4' ≤ 0.9, and 0 ≤ b5 ≤ 0.6; more preferably 0.2 ≤ b2 ≤ 0.4, 0.2 ≤ b4 ≤ 0.8, 0 ≤ b4' ≤ 0.5, 0 ≤ b5 ≤ 0.5, 0.1 ≤ b2 + b4 ≤ 1.0, 0.1 ≤ b2 + b4' ≤ 1.0, 0.1 ≤ b2 + b4 + b4' ≤ 1.0, 0 ≤ b6 ≤ 0.5, 0 ≤ b7 ≤ 0.5, and 0 ≤ b8 ≤ 0.5. Note that the total of these repeating units is 100 mol% of the total amount of all the repeating units.

The crosslinkable polymer compound (B) used in the present invention preferably has a weight-average molecular weight of 1,000 to 500,000, in particular, 2,000 to 30,000 in terms of polystyrene determined by gel permeation chromatography (GPC). When the weight-average molecular weight is greater than these lower limits, glass transition temperature becomes sufficiently high, so that the pattern does not become deformed in heat crosslinking after development of the negative photosensitive resin composition. When the weight-average molecular weight is less than the upper limit, there is no risk of pinhole defects occurring on application.

Note that it is also possible to blend two or more polymers having different composition ratios, molecular weight distributions, or molecular weights.

In this event, the crosslinkable polymer compound (B) is preferably added in an amount of 10 parts by mass or more and 100 parts by mass or less relative to 100 parts by mass of the alkali-soluble resin (A). When the added amount is 10 parts by mass or more, a cured film with the above-described alkali-soluble resin (A) becomes tough. When the added amount is 100 parts by mass or less, the tensile strength of the cured film does not become degraded. Therefore, the added amount of the crosslinkable polymer compound (B) is preferably within the above range. The added amount of the component (B) is more preferably 10 parts by mass or more and 70 parts by mass or less, further preferably 30 parts by mass or more and 50 parts by mass or less. When the amount is set to this range, the balance between the lithography patterning performance and the physical properties of the cured film becomes excellent.

### [(C) Compound That Generates Acid by Light]

The compound that generates an acid by light (C) of the present invention can be any compound that generates an acid by light as long as it is a compound that generates an acid by irradiation with a high energy beam. Suitable compounds include sulfonium salts, iodonium salts, sulfonyldiazomethanes, N-sulfonyloxyimide acid generators, benzoinsulfonate acid generators, pyrogallol trisulfonate acid generators, nitrobenzene sulfonate acid generators, sulfone acid generators, acid generators in the form of glyoxime derivatives, and the like. Details will be given below, and one of these may be used or a mixture of two or more thereof may be used.

Sulfonium salts are salts of sulfonium cations with sulfonates. Exemplary sulfonium cations include triphenylsulfonium, (4-tert-butoxyphenyl)diphenylsulfonium, bis(4-tert-butoxyphenyl)phenylsulfonium, tris(4-tert-butoxyphenyl)sulfonium, (3-tert-butoxyphenyl)diphenylsulfonium, bis(3-tert-butoxyphenyl)phenylsulfonium, tris(3-tert-butoxyphenyl)sulfonium, (3,4-di-tert-butoxyphenyl)diphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, (4-tert-butoxycarbonylmethyloxyphenyl)diphenylsulfonium, tris(4-tert-butoxycarbonylmethyloxyphenyl)sulfonium, (4-tert-butoxyphenyl)bis (4-dimethylaminophenyl) sulfonium, tris(4-dimethylaminophenyl)sulfonium, 2-naphthyldiphenylsulfonium, dimethyl-2-naphthylsulfonium, 4-hydroxyphenyldimethylsulfonium, 4-methoxyphenyldimethylsulfonium, trimethylsulfonium, 2-oxocyclohexylcyclohexylmethylsulfonium, trinaphthylsulfonium, tribenzylsulfonium, and the like. Exemplary sulfonates include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, methanesulfonate, and the like. Sulfonium salts based on combination of the foregoing examples are included.

Iodonium salts are salts of iodonium cations with sulfonates. Exemplary iodonium cations are aryliodonium cations including diphenyliodinium, bis(4-tert-butylphenyl)iodonium, 4-tert-butoxyphenylphenyliodonium, 4-methoxyphenylphenyliodonium, and the like. Exemplary sulfonates include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, methanesulfonate, and the like. Iodonium salts based on combination of the foregoing examples are included.

Exemplary sulfonyldiazomethane compounds include bissulfonyldiazomethane compounds and sulfonylcarbonyldiazomethane compounds such as bis(ethylsulfonyl)diazomethane, bis(1-methylpropylsulfonyl)diazomethane, bis(2-methylpropylsulfonyl)diazomethane, bis(1,1-dimethylethylsulfonyl)diazomethane, bis(cyclohexylsulfonyl)diazomethane, bis(perfluoroisopropylsulfonyl)diazomethane, bis(phenylsulfonyl)diazomethane, bis(4-methylphenylsulfonyl)diazomethane, bis(2,4-dimethylphenylsulfonyl)diazomethane, bis(2-naphthylsulfonyl)diazomethane, 4-methylphenylsulfonylbenzoyldiazomethane, tertbutylcarbonyl-4-methylphenylsulfonyldiazomethane, 2-naphthylsulfonylbenzoyldiazomethane, 4-methylphenylsulfonyl-2-naphthoyldiazomethane, methylsulfonylbenzoyldiazomethane, and tertbutoxycarbonyl-4-methylphenylsulfonyldiazomethane.

N-sulfonyloxyimide photo-acid generators include combinations of imide skeletons with sulfonates. Exemplary imide skeletons include succinimide, naphthalene dicarboxylic acid imide, phthalimide, cyclohexyldicarboxylic acid imide, 5-norbornene-2,3-dicarboxylic acid imide, 7-oxabicyclo[2.2.1]-5-heptene-2,3-dicarboxylic acid imide, and the like. Exemplary sulfonates include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, methanesulfonate, and the like.

Benzoinsulfonate photo-acid generators include benzoin tosylate, benzoin mesylate, benzoin butanesulfonate, and the like.

Pyrogallol trisulfonate photo-acid generators include pyrogallol, phloroglucin, catechol, resorcinol, and hydroquinone, in which all the hydroxy groups are substituted by trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, methanesulfonate, and the like.

Nitrobenzyl sulfonate photo-acid generators include 2,4-dinitrobenzyl sulfonate, 2-nitrobenzyl sulfonate, and 2,6-dinitrobenzyl sulfonate, with exemplary sulfonates including trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate,

butanesulfonate, methanesulfonate, and the like. Also useful are analogous nitrobenzyl sulfonate compounds in which the nitro group on the benzyl side is substituted with a trifluoromethyl group.

Examples of sulfone photo-acid generators include bis(phenylsulfonyl)methane, bis(4-methylphenylsulfonyl)methane, bis(2-naphthylsulfonyl)methane, 2,2-bis(phenylsulfonyl)propane, 2,2-bis(4-methylphenylsulfonyl)propane, 2,2-bis(2-naphthylsulfonyl)propane, 2-methyl-2-(p-toluenesulfonyl)propiophenone, 2-cyclohexylcarbonyl-2-(p-toluenesulfonyl)propane, and 2,4-dimethyl-2-(p-toluenesulfonyl)pentan-3-one.

Examples of photo-acid generators in the form of glyoxime derivatives include bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedioneglyoxime, bis-o-(p-toluenesulfonyl)-2-methyl-3,4-pentanedioneglyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedioneglyoxime, bis-o-(n-butanesulfonyl)-2-methyl-3,4-pentanedioneglyoxime, bis-o-(methanesulfonyl)-a-dimethylglyoxime, bis-o-(trifluoromethanesulfonyl)-a-dimethylglyoxime, bis-o-(1,1,1-trifluoroethanesulfonyl)-α-dimethylglyoxime, bis-o-(tert-butanesulfonyl)-α-dimethylglyoxime, bis-o-(perfluorooctanesulfonyl)-α-dimethylglyoxime, bis-o-(cyclohexylsulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime, bis-o-(camphorsulfonyl)-α-dimethylglyoxime, and the like.

In particular, preferably used photo-acid generators are bissulfonyldiazomethane and N-sulfonyloxyimide.

Furthermore, an oxime-type acid generator shown in WO 2004/074242 A2 can also be added.

One of the above-described acid generators may be used or a combination of two or more thereof may be used. Onium salts have an excellent effect of enhancing rectangularity, diazomethane derivatives and glyoxime derivatives have an excellent effect of reducing standing waves. Therefore, it is possible to make fine adjustments to profiles by combining the two.

The blending amount of the photo-acid generator in the inventive negative photosensitive resin composition is preferably 0.05 to 20 parts by mass, particularly preferably 1 to 10 parts by mass relative to 100 parts by mass of the component (A). When the blending amount is 0.05 parts by mass or more, sufficient contrast (difference between the exposed parts and the unexposed parts in the speed of dissolution to a developer) can be achieved. When the blending amount is 20 parts by mass or less, there is no risk of resolution being degraded due to light absorption of the acid generator itself.

### [(D) Crosslinking Agent Other Than Component (B)]

The crosslinking agent (D) of the present invention can be any crosslinking agent as long as it is a crosslinking agent other than the above-described component (B), and is a compound having a group crosslinked with the component (A). Specific examples of crosslinking agents that can be used here include melamine compounds, guanamine compounds, glycoluril compounds, or urea compounds substituted with at least one group selected from a methylol group, an alkoxymethyl group, and an acyloxymethyl group, epoxy compounds, oxetane compounds, isocyanate compounds, azide compounds, compounds having a double bond such as an alkenyl ether group, compounds having benzylalcohol, etc. and oxazoline-based crosslinking agents disclosed in JP H2-60941 A, JP H2-99537 A, and JP H2-115238 A.

Among the specific examples of the crosslinking agents described above, further examples of epoxy compounds include tris(2,3-epoxypropyl)isocyanurate, trimethylol methane triglycidyl ether, trimethylol propane triglycidyl ether, triethylol ethane triglycidyl ether, and the like.

Other examples include those having a hydroxy group of the following compounds converted to a glycidyl ether: phenol, o-cresol, m-cresol, p-cresol, 2,3-dimethylphenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-t-butylphenol, 3-t-butylphenol, 4-t-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-t-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-t-butyl-5-methylphenol, pyrogallol, thymol, isothymol, 4,4'-(9H-fluorene-9-ylidene)bisphenol, 2,2'dimethyl-4,4'-(9H-fluorene-9-ylidene)bisphenol, 2,2'diallyl-4,4'-(9H-fluorene-9-ylidene)bisphenol, 2,2'difluoro-4,4'-(9H-fluorene-9-ylidene)bisphenol, 2,2'diphenyl-4,4'-(9H-fluorene-9-ylidene)bisphenol, 2,2'dimethoxy-4,4'-(9H-fluorene-9-ylidene)bisphenol, 2,3,2',3'-tetrahydro-(1,1')-spirobiindene-6,6'-diol, 3,3,3',3'-tetramethy1-2,3,2',3'-tetrahydro-(1,1')-spirobiindene-6,6'-diol, 3,3,3',3',4,4'-hexamethyl-2,3,2',3'-tetrahydro-(1,1')-spirobiindene-6,6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol. In addition, examples include novolak resins of the above-described phenolic compounds whose hydroxy group is converted to a glycidyl ether.

Specific examples of the melamine compound include hexamethylolmelamine, hexamethoxymethyl melamine, compounds in which 1 to 6 methylol groups of hexamethylolmelamine are converted into methoxymethyl groups or a mixture thereof, hexamethoxyethyl melamine, hexaacyloxymethyl melamine, and compounds in which 1 to 6 methylol groups of hexamethylolmelamine are converted into acyloxymethyl groups or a mixture thereof. Examples of the guanamine compound include tetramethylol guanamine, tetramethoxymethyl guanamine, compounds in which 1 to 4 methylol groups of tetramethylol guanamine are converted into methoxymethyl groups or a mixture thereof, tetramethoxyethyl guanamine, tetraacyloxy guanamine, and compounds in which 1 to 4 methylol groups of tetramethylol guanamine are converted into acyloxymethyl groups or a mixture thereof. Examples of the glycoluril compound include tetramethylol glycoluril, tetramethoxy glycoluril, tetramethoxymethyl glycoluril, compounds in which 1 to 4 methylol groups of tetramethylol glycoluril are converted into methoxymethyl groups or a mixture thereof, and compounds in which 1 to 4 methylol groups of tetramethylol glycoluril are converted into acyloxymethyl groups or a mixture thereof. Examples of the urea compound include tetramethylolurea, tetramethoxymethylurea, compounds in which 1 to 4 methylol groups of tetramethylolurea are converted into methoxymethyl groups or a mixture thereof, and tetramethoxyethylurea.

Illustrative examples of the isocyanate compound include trilene diisocyanate, diphenylmethane diisocyanate, hexamethylene diisocyanate, and cyclohexane diisocyanate. Illustrative examples of the azide compound include 1,1'-biphenyl-4,4'-bisazide, 4,4'-methylidenebisazide, and 4,4'-oxybisazide.

Illustrative examples of the compound containing an alkenyl ether group include ethyleneglycol divinyl ether, triethyleneglycol divinyl ether, 1,2-propanediol divinyl ether, 1,4-butanediol divinyl ether, tetramethyleneglycol divinyl ether, neopentyl glycol divinyl ether, trimethylolpropane trivinyl ether, hexanediol divinyl ether, 1,4-cyclohexanediol divinyl ether, pentaerythritol trivinyl ether, pentaerythritol tetravinyl ether, sorbitol tetravinyl ether, sorbitol pentavinyl ether, and trimethylolpropane trivinyl ether.

Further examples include cyclic epoxy compounds disclosed in JP H11-100378 A, JP 2003-231860 A, JP 2005-146038 A, JP 2005-290052 A, JP 2006-199790 A, and JP 2006-273748 A; crosslinking agents having an oxirane ring bonded to a ring disclosed in JP 2006-348252 A; epoxy crosslinking agents having a dendrimer or a hyperbranched polymer as a base disclosed in JP 2008-24920 A; crosslinking agents having both a hydroxy group and an oxetanyl group disclosed in JP 2001-310937 A; and crosslinking agents having both a hydroxy group and an epoxy group disclosed in JP 3824286 B.

An epoxy group has a great distortion in the ring and has high reactivity, but oxetane has high basicity and is easily bonded with an acid. It is reported that reactivity in cation polymerization is remarkably improved by combining an epoxy group with an oxetanyl group.

Furthermore, the component (D) in the inventive negative photosensitive resin composition is more preferably one or more kinds of crosslinking agents selected from an amino condensate modified by formaldehyde or formaldehyde-alcohol; and a phenol compound having two or more methylol groups or alkoxymethylol groups by average in one molecule.

Examples of the amino condensates modified by the formaldehyde or formaldehyde-alcohol include a melamine condensate modified by the formaldehyde or formaldehyde-alcohol, and a urea condensate modified by the formaldehyde or formaldehyde-alcohol.

The melamine condensate modified by the formaldehyde or formaldehyde-alcohol is prepared, for example, in such a manner that, firstly, according to a well-known method, a melamine monomer is modified by methylol reaction with formalin, or this is further modified by alkoxylation with alcohol, thus modified melamine represented by the following general formula (22) is obtained. As the alcohol, a lower alcohol, for example an alcohol having 1 to 4 carbon atoms is preferable. 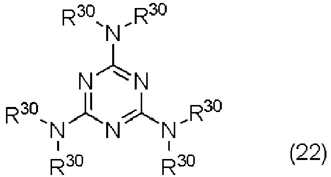 In the formula, R³⁰s may be the same or different from each other, and is a methylol group, an alkoxymethyl group containing an alkoxy group having 1 to 4 carbon atoms or a hydrogen atom, and at least one R³⁰ is a methylol group or the alkoxymethyl group.

Examples of the R³⁰ include a methylol group, an alkoxymethyl group such as a methoxymethyl group and an ethoxymethyl group, and a hydrogen atom, etc.

Specific examples of the modified melamine represented by the general formula (22) include trimethoxymethylmonomethylol melamine, dimethoxymethylmonomethylol melamine, trimethylol melamine, hexamethylol melamine, and hexamethoxymethylol melamine. Next, the modified melamine represented by the general formula (22) or its multimer (for example, an oligomer such as a dimer or a trimer) is subjected to addition condensation polymerization with formaldehyde until a desired molecular weight is obtained according to the conventional method to obtain a melamine condensate modified by formaldehyde or formaldehyde-alcohol.

The urea condensate modified by the formaldehyde or formaldehyde-alcohol is prepared according to, for example, a well-known method, by modifying a urea condensate having a desired molecular weight by methylol reaction with formaldehyde, or by further modifying by alkoxylation with alcohol.

Specific examples of the urea condensate modified by the formaldehyde or formaldehyde-alcohol include, for example, a methoxymethylated urea condensate, an ethoxymethylated urea condensate, a propoxymethylated urea condensate, and the like.

These modified melamine condensates and modified urea condensates may be used by one kind or by mixing two or more kinds.

Next, examples of the phenol compound having two or more methylol groups or alkoxymethylol groups in average in one molecule include (2-hydroxy-5-methyl)-1,3-benzenedimethanol, 2,2',6,6'-tetramethoxymethylbisphenol A, compounds represented by the following formulae (D-3) to (D-7), and the like.

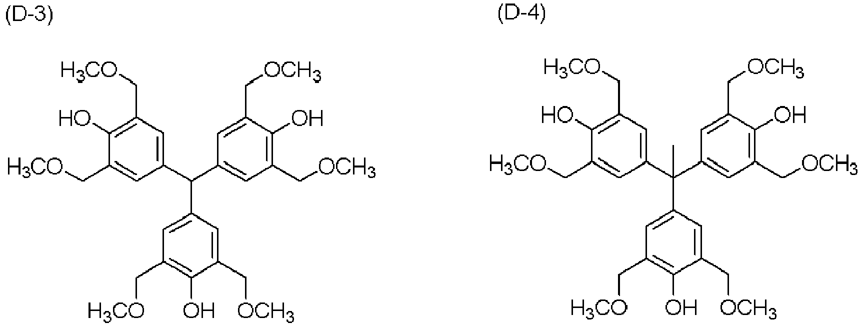

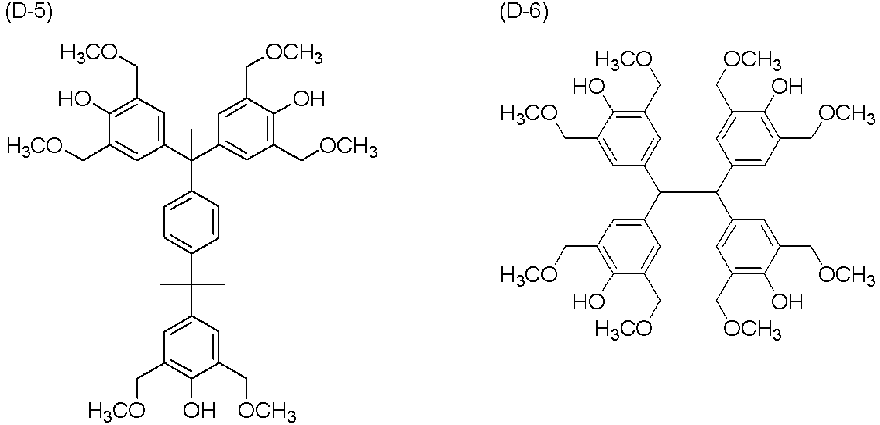

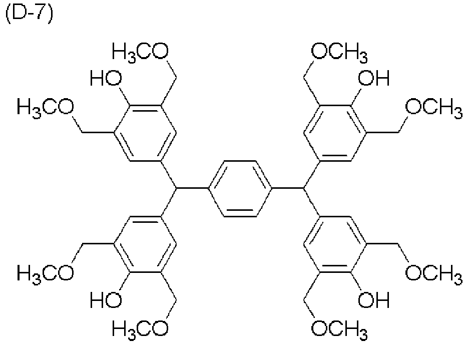

One of the crosslinking agents may be used or two or more kinds may be used in combination.

The component (D) undergoes a crosslinking reaction with (A) and (B) in the PEB step of the inventive negative photosensitive resin composition with the acid generated from (C) as a catalyst. Furthermore, the component (D) is a component that causes a crosslinking reaction in the subsequent post-curing to further increase the strength of a cured product. A weight-average molecular weight of such a component (D) is preferably 150 to 10,000, and particularly preferably 200 to 3,000, from the viewpoint of the photocurability and heat resistance.

Furthermore, in the inventive negative photosensitive resin composition, a blending amount of the component (D) is preferably 0.5 to 50 parts by mass, and particularly preferably 1 to 30 parts by mass relative to 100 parts by mass of the component (A).

### [(E) Basic Compound]

The inventive negative photosensitive resin composition can further contain, in addition to the components (A), (B), (C), and (D) that are essential components, (E) a basic compound. The component (E) basic compound is suitably a compound which can suppress a diffusion rate of the acid generated from the photo-acid generator when the acid is diffused in the resist film. By blending such a basic compound, the diffusion rate of the acid in the resist film is suppressed, so that resolution can be improved, change in sensitivity after exposure can be suppressed, a substrate or environment dependency can be reduced, and exposure margin or pattern profile, etc. can be improved.

Examples of the basic compound include primary, secondary and tertiary aliphatic amines, mixed amines, aromatic amines, hetrocyclic amines, a nitrogen-containing compound having a carboxy group, a nitrogen-containing compound having a sulfonyl group, a nitrogen-containing compound having a hydroxy group, a nitrogen-containing compound having a hydroxyphenyl group, an alcoholic nitrogen-containing compound, amide derivatives, and imide derivatives, etc.

Specifically, examples of the primary aliphatic amines include, ammonia, methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, tetraethylenepentamine, etc. Examples of the secondary aliphatic amines include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, N,N-dimethyltetraethylenepentamine, etc. Examples of the tertiary aliphatic amines include trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, N,N,N',N'-tetramethyltetraethylenepentamine, etc.

Examples of the mixed amines include dimethylethylamine, methylethylpropylamine, benzylamine, a phenethyl amine, benzyldimethylamine, etc. Specific examples of the aromatic amines and the heterocyclic amines include aniline derivatives (for example, aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, N,N-dimethyltoluidine, etc.), diphenyl(p-tolyl)amine, methyldiphenylamine, triphenylamine, phenylenediamine, naphthylamine, diaminonaphthalene, pyrrole derivatives (for example, pyrrole, 2H-pyrrole, 1-methylpyrrole, 2,4-dimethylpyrrole, 2,5-dimethylpyrrole, N-methylpyrrole, etc.), oxazole derivatives (for example, oxazole, isoxazole, etc.), thiazole derivatives (for example, thiazole, isothiazole, etc.), imidazole derivatives (for example, imidazole, 4-methylimidazole, 4-methyl-2-phenylimidazole, etc.), pyrazole derivatives, furazan derivatives, pyrroline derivatives (for example, pyrroline, 2-methyl-1-pyrroline, etc.), pyrrolidine derivatives (for example, pyrrolidine, N-methylpyrrolidine, pyrrolidinone, N-methylpyrrolidone, etc.), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridine, 4-pyrrolidinopyridine, 1-methyl-4-phenylpyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperadine derivatives, morpholine derivatives, indole derivatives, isoindole derivatives, 1H-indazole derivatives, indoline derivatives, quinoline derivatives (for example, quinoline, 3-quinolinecarbonitrile, etc.), isoquinoline derivatives, cinnoline derivatives, quinazoline derivatives, quinoxaline derivatives, phthalazine derivatives, purine derivatives, puteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives, etc.

Furthermore, examples of the nitrogen-containing compound having a carboxy group include aminobenzoic acid, indolecarboxylic acid, amino acid derivatives (for example, nicotinic acid, alanine, arginine, aspartic acid, glutamic acid, glycine, histidine, isoleucine, glycyrleucine, leucine, methionine, phenylalanine, threonine, lysine, 3-aminopyrazine-2-carboxylic acid, methoxyalanine, etc.), etc. Examples of the nitrogen-containing compound having a sulfonyl group include 3-pyridine sulfonic acid, pyridinium p-tolueneslfonate, etc. Examples of the nitrogen-containing compound having a hydroxy group, the nitrogen-containing compound having a hydroxyphenyl group, and the alcoholic nitrogen-containing compound include 2-hydroxypyridine, aminocresol, 2,4-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperadine, 1-[2-(2-hydroxyethoxy)ethyl]piperadine, piperidineethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyjulolidine, 3-quinuclidinol, 3-tropanol, 1-methyl-2-pyrrolidineethanol, 1-aziridine ethanol, N-(2-hydroxyethyl)phthalimide, N-(2-hydroxyethyl)isonicotinamide, etc. Examples of the amide derivatives include formamide, N-methylformamide, N,N-dimethylformamide, acetamide, N-methylacetamide, N,N-dimethylacetamide, propionamide, benzamide, etc. Examples of the imide derivatives include phthalimide, succinimide, maleimide, etc.

One kind of the basic compound can be used or a combination of two or more kinds can be used. When 0 to 2 parts by mass of the basic compound is to be blended relative to 100 parts by mass of the component (A) alkali-soluble resin, a basic compound being a mixture with the blending amount of 0.01 to 2 parts by mass, in particular, 0.01 to 1 part by mass is suitable. When the blending amount is 2 parts by mass or less, sufficient sensitivity can be sustained.

### [(F) Thermal Acid Generator]

The inventive negative photosensitive resin composition may further contain (F) a compound that generates an acid by heat (thermal acid generator). The compound generating an acid by heat of the component (F) may be added to thermally expedite a crosslinking reaction of the component (A) with the component (B) and the component (D) in a step of heating and post-curing in a temperature of 100 to 300°C performed after the pattern formation.

In particular, as the component (F), a preferable component is one that does not encourage the curing of a film and does not disturb the pattern formation until a pattern is formed by development. In order to realize this, the component (F) is preferably one that, after the photosensitive resin composition is applied, does not generate an acid at a temperature in a step of removing a solvent and drying, but generates an acid by a heat treatment after pattern formation to encourage the curing of the pattern or a film of the negative photosensitive resin composition. Specifically, a compound that is decomposed by a heat treatment at 100°C to 300°C, preferably at 150°C to 300°C to generate an acid is preferable. By containing such a component (F), crosslinking and curing reaction of the pattern or the film of the negative photosensitive resin composition can be further promoted in the step of heating and post-curing at a temperature of 100 to 300°C after patterning. The component (F) makes it possible to further improve the mechanical strength, the chemical resistance, the adhesiveness or the like of the obtained pattern or film, by further forwarding the crosslinking and the curing reaction.

As the compound that generates an acid by a suitable heat, compounds described in paragraphs [0061] to [0085] of JP 2007-199653 A may be exemplified.

A blending amount of the compound that generates an acid by heat is preferably 0.1 part by mass or larger, more preferably 0.5 parts by mass or larger, and preferably 30 parts by mass or smaller, and more preferably 5 parts by mass or smaller relative to 100 parts by mass of the component (A) in the inventive negative photosensitive resin composition. When the contained amount is 0.1 part by mass or larger, the crosslinking reaction can be promoted. Meanwhile, when the contained amount is 30 parts by mass or smaller, alkali-developing properties of the composition are not degraded, so that development residue is not generated.

### [(G) Antioxidant]

The inventive negative photosensitive resin composition can further contain (G) an antioxidant. Degradation of an aliphatic group or a phenolic hydroxy group of the component (A) by oxidation can be suppressed by the component (G) antioxidant being contained. In addition, by an anticorrosive effect to metal materials, it is possible to suppress oxidation of metal by water from outside, a photo-acid generator, or a thermal acid generator, etc. and accompanying adhesion degradation and delamination.

Specific examples of antioxidants that can be used here include hindered phenol-based antioxidants, phosphorus-based antioxidants and sulfur-based antioxidants as preferable examples. However, the antioxidant is not limited thereto. Moreover, one of these antioxidants can be used or two or more thereof can be used in combination.

Furthermore, out of the above-described specific examples of antioxidants, examples of the hindered phenol-based antioxidants include pentaerythritol tetrakis[3-(3,5-di-tert-butyl-4-hydroxyphenyl)propionate] (Irganox 1010 (trade name), manufactured by BASF Japan Ltd.), thiodiethylenebis[3-(3,5-di-tert-butyl-4-hydroxyphenyl)propionate] (Irganox 1035 (trade name), manufactured by BASF Japan Ltd.), octadecyl[3-(3,5-di-tert-butyl-4-hydroxyphenyl)propionate] (Irganox 1076 (trade name), manufactured by BASF Japan Ltd.), octyl-1-3,5-di-tert-butyl-4-hydroxy-hydrocinnamic acid (Irganox 1135 (trade name), manufactured by BASF Japan Ltd.), 4,6-bis(octylthiomethyl-o-cresol) (Irganox 1520L, manufactured by BASF Japan Ltd.), Sumilizer GA80 (trade name, manufactured by Sumitomo Chemical Co., Ltd.), Adekastab AO-20 (trade name, manufactured by ADEKA CORPORATION), Adekastab AO-30 (trade name, manufactured by ADEKA CORPORATION), Adekastab AO-40 (trade name, manufactured by ADEKA CORPORATION), Adekastab AO-50 (trade name, manufactured by ADEKA CORPORATION), Adekastab AO-60 (trade name, manufactured by ADEKA CORPORATION), Adekastab AO-80 (trade name, manufactured by ADEKA CORPORATION), Adekastab AO-330 (trade name, manufactured by ADEKA CORPORATION), hindered phenol-based antioxidants disclosed in WO 2017/188153 A1, and the like.

Furthermore, out of the above-described specific examples of antioxidants, examples of the phosphorus-based antioxidants include triphenyl phosphite, tris(methylphenyl) phosphite, triisooctyl phosphite, tridecyl phosphite, tris(2-ethylhexyl) phosphite, tris(nonylphenyl) phosphite, tris(octylphenyl) phosphite, tris[decylpoly(oxyethylene) phosphite, tris(cyclohexylphenyl) phosphite, tricyclohexyl phosphite, tri(decyl)thio phosphite, triisodecylthio phosphite, phenyl-bis(2-ethylhexyl) phosphite, phenyl-diisodecyl phosphite, tetradecylpoly(oxyethylene)-bis(ethylphenyl) phosphite, phenyl-dicyclohexyl phosphite, phenyl-diisooctyl phosphite, phenyl-di(tridecyl) phosphite, diphenyl-cyclohexyl phosphite, diphenyl-isooctyl phosphite, diphenyl-2-ethylhexyl phosphite, diphenyl-isodecyl phosphite, diphenyl-cyclohexylphenyl phosphite, diphenyl-(tridecyl)thio phosphite, and the like.

Furthermore, out of the above-described specific examples of antioxidants, examples of the sulfur-based antioxidants include Adekastab AO-412S (trade name, manufactured by ADEKA CORPORATION), AO-503S (trade name, manufactured by ADEKA CORPORATION), Sumilizer TP-D (trade name, manufactured by Sumitomo Chemical Co., Ltd.), and the like.

Sulfur-based antioxidants and phosphorus-based antioxidants can be expected to have an effect of decomposing peroxides.

The blending amount of (G) the antioxidant is preferably 0.1 to 10 parts by mass, more preferably 0.2 to 5 parts by mass relative to 100 parts by mass of the component (A) alkali-soluble resin. When the contained amount is 0.1 part by mass or more, adhesiveness to metal materials is enhanced, while at the same time, delamination is suppressed. Meanwhile, when the contained amount is 10 parts by mass or less, the alkali developing properties of the composition and the toughness of the cured film are not degraded.

### [(H) Silane Compound]

The inventive negative photosensitive resin composition can further contain (H) a silane compound. When the component (H) silane compound is contained, not only is the adhesiveness to metal materials enhanced, it is also possible to suppress the delamination of the cured film in reliability tests such as a thermal shock test and a high temperature and high humidity test.

A silane compound that can be used here can be any silane compound as long as the silane compound has an alkoxysilyl group. Suitable, specific examples include the following: γ-glycidoxypropyltriethoxysilane, γ-glycidoxypropyltrimethoxysilane, 2-(3,4-epoxycyclohexyl)ethyltrimethoxysilane, bis(2-hydroxyethyl)-3-aminopropyl-triethoxysilane, γ-aminopropyltrimethoxysilane, γ-aminopropyltriethoxysilane, vinyltriethoxysilane, vinyltrimethoxysilane, γ-methacryloxypropyltrimethoxysilane, γ-acryloxypropyltrimethoxysilane, 3-mercaptopropyltrimethoxysilane, 3-isocyanatepropyltriethoxysilane, bis(2-hydroxyethyl)-3-aminopropyltriethoxysilane, triethoxysilylpropylethyl carbamate, 3-(triethoxysilyl)propyl succinic anhydride, phenyltriethoxysilane, phenyltrimethoxysilane, N-phenyl-3-aminopropyltrimethoxysilane, 3-triethoxysilyl-N-(1,3-dimethylbutylidene)propylamine, amide group-containing silane compounds disclosed in JP 6414060 B, thiourea group-containing silane compounds disclosed in WO 2016/140024 A and JP 5987984 B, thiol group-containing silane compounds disclosed in JP 2017-044964 A, and the like. However, the silane compound is not limited thereto. Furthermore, one of these silane compounds can be used or a combination of two or more thereof can be used.

The contained amount of (H) the silane compound is preferably 0.1 to 20 parts by mass, more preferably 1 to 10 parts by mass, and further preferably 3 to 6 parts by mass relative to 100 parts by mass of the component (A) alkali-soluble resin. With 0.1 part by mass or more, more sufficient adhesiveness with a substrate can be provided, and when 20 parts by mass or less, it is possible to further suppress the problem of increasing viscosity or the like when storing at room temperature. Meanwhile, when the contained amount is less than 10 parts by mass, the alkali developing properties of the composition are not degraded, so that development residue is not caused.

### [Other Components]

In the inventive negative photosensitive resin composition, components other than the components (A), (B), (C), (D), (E), (F), (G), and (H) may be further contained. Examples of such other components include (I) a dissolution inhibitor, (J) a surfactant, (K) a solvent, and the like. The compounds exemplified below or the like can be suitably used. However, the compounds are not limited thereto.

Examples of (I) the dissolution inhibitor include compounds having two or more phenolic hydroxy groups in a molecule, where an average of 0 to 100 mol% of the hydrogen atoms of the phenolic hydroxy groups are substituted with acid-labile groups as a whole; or compounds having a carboxy group in a molecule, where an average of 50 to 100 mol% of the hydrogen atoms of the carboxy groups are substituted with acid-labile groups as a whole. In addition, the compounds have a weight-average molecular weight of 100 to 1,000, preferably 150 to 800.

The degree of substitution of the hydrogen atoms in the phenolic hydroxy groups with the acid-labile groups is, on average, 0 mol% or higher, preferably 30 mol% or higher of all the phenolic hydroxy groups, and the upper limit of the degree is 100 mol%, more preferably 80 mol%. The degree of substitution of the hydrogen atoms in the carboxy groups with the acid-labile group is, on average, 50 mol% or higher, preferably 70 mol% or higher of all the carboxy groups, and the upper limit of the degree is 100 mol%.

In this case, compounds represented by the following formulae (I1) to (114) are preferable as the compounds having two or more phenolic hydroxy groups or the compounds having a carboxy group.

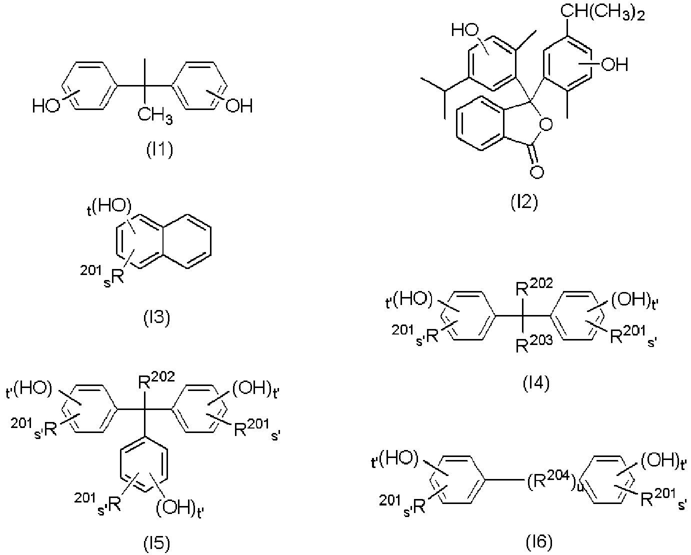

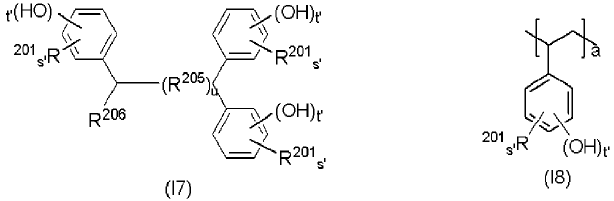

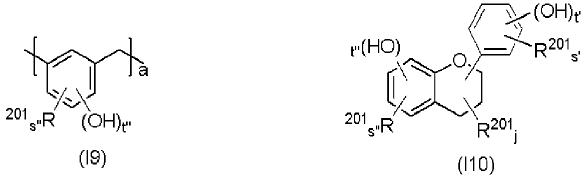

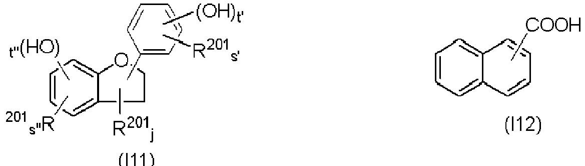

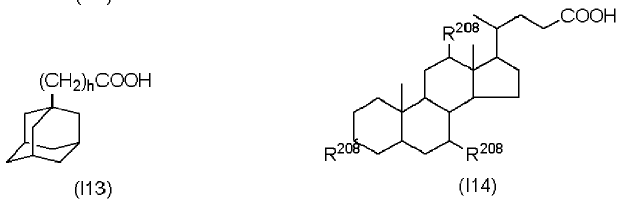

In the formulae, R²⁰¹ and R²⁰² each represent a hydrogen atom or a linear or branched alkyl group or alkenyl group having 1 to 8 carbon atoms. R²⁰³ represents a hydrogen atom or a linear or branched alkyl group or alkenyl group having 1 to 8 carbon atoms. R²⁰⁴ represents -(CH₂)ᵢ-(i=2 to 10), an arylene group having 6 to 10 carbon atoms, a carbonyl group, a sulfonyl group, an oxygen atom, or a sulfur atom. R²⁰⁵ represents an alkylene group having 1 to 10 carbon atoms, an arylene group having 6 to 10 carbon atoms, a carbonyl group, a sulfonyl group, an oxygen atom, or a sulfur atom. R²⁰⁶ represents a hydrogen atom, a linear or branched alkyl group or alkenyl group having 1 to 8 carbon atoms, or a phenyl group or a naphthyl group each substituted with a hydroxy group. R²⁰⁸ represents a hydrogen atom or a hydroxy group. "j" is an integer of 0 to 5. "u" and "h" are 0 or 1. "s", "t", "s'", "t''', "s"'', and "t'''' each satisfy s + t = 8, s' + t' = 5, and s" + t" = 4, and are numbers such that there is at least one hydroxy group in each phenyl skeleton. "a" is a number that gives a molecular weight of 100 to 1,000 to the compounds of the formulae (18) and (19).

The blending amount of the dissolution inhibitor is 0 to 50 parts by mass, preferably 5 to 50 parts by mass, more preferably 5 to 20 parts by mass relative to 100 parts by mass of the component (A) alkali-soluble resin. One dissolution inhibitor can be used or a mixture of two or more thereof can be used. When the blending amount is sufficient, resolution can be enhanced, and when the amount is 50 parts by mass or less, film loss of patterns does not occur, so that high resolution can be achieved.

As the (J) surfactant, a nonionic surfactant is preferable. Examples thereof include fluorinated surfactants, specifically, perfluoroalkyl polyoxyethylene ethanol, fluorinated alkyl ester, perfluoroalkylamine oxide, a fluorine-containing organosiloxane compound, and a nonfluorinated organosiloxane compound.

As these surfactants, commercially available ones may be used. Examples thereof include Fluorad FC-4430 (trade name, manufactured by Sumitomo 3M Limited), PF-6320 (trade name, manufactured by OMNOVA Solutions Inc.), PF-636 (trade name, manufactured by OMNOVA Solutions Inc.), Surflon S-141 and S-145 (both trade names, manufactured by ASAHI GLASS CO., LTD.), UNIDYNE DS-401, DS-4031, and DS-451 (all trade names, manufactured by DAIKIN INDUSTRIES, LTD.), Megafac F-8151 (trade name, manufactured by DIC Corporation), X-70-093 (trade name, manufactured by Shin-Etsu Chemical Co., Ltd.), etc. Among these, preferred are Fluorad FC-4430 (trade name, manufactured by Sumitomo 3M Limited), PF-6320 (trade name, manufactured by OMNOVA Solutions Inc.), PF-636 (trade name, manufactured by OMNOVA Solutions Inc.), and X-70-093 (trade name, manufactured by Shin-Etsu Chemical Co., Ltd.).

The blending amount of the surfactant is preferably 0.01 to 5 parts by mass, more preferably 0.01 to 3 parts by mass relative to 100 parts by mass of the component (A) alkali-soluble resin.

The (K) solvent is not limited as long as it can dissolve the component (A), the component (B), the component (C), and the component (D). Examples of the solvent include: ketones such as cyclohexanone, cyclopentanone, methyl-2-n-amyl ketone, and the like; alcohols such as 3-methoxybutanol, 3-methyl-3-methoxybutanol, 1-methoxy-2-propanol, 1-ethoxy-2-propanol, and the like; ethers such as propylene glycol monomethyl ether, ethylene glycol monomethyl ether, propylene glycol monoethyl ether, ethylene glycol monoethyl ether, propylene glycol dimethyl ether, diethylene glycol dimethyl ether, and the like; esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, γ-butyrolactone, and the like. One or more kinds thereof may be used. In particular, ethyl lactate, cyclohexanone, cyclopentanone, propylene glycol monomethyl ether acetate, γ-butyrolactone or a mixed solvent thereof is preferable.

A blending amount of the component (K) is preferably 50 to 2,000 parts by mass, particularly preferably 100 to 1,000 parts by mass relative to 100 parts by mass of the total of the blending amounts of the component (A), the component (B), the component (C), and the component (D).

### (Patterning Process)

The present invention provides a patterning process including the following steps.
(1) A step of forming a photosensitive material film by coating a substrate with the above-described negative photosensitive resin composition;
(2) subsequently, after a heat treatment, a step of exposing the photosensitive material film with a high energy beam having a wavelength of 190 to 500 nm or an electron beam via a photomask; and
(3) after irradiation, a step of developing the substrate, which has been heat-treated, with a developer of an alkaline aqueous solution.

In the following, a patterning process using the inventive negative photosensitive resin composition will be described.

In the inventive negative photosensitive resin composition, in order to form a pattern, a well-known lithography technology may be adopted and performed. For example, on a silicon wafer, a SiO₂ substrate, a SiN substrate, or a substrate on which a pattern such as copper wiring is formed, the negative photosensitive resin composition is applied by a technique of spin-coating (spin-coating method), followed by pre-baking under the condition at 80 to 130°C, and for about 50 to 600 seconds to form a photosensitive material film having a thickness of 1 to 50 µm, preferably 1 to 30 µm, and further preferably 1 to 20 µm.

According to the spin-coating method, after dispensing about 5 mL of the negative photosensitive resin composition on such a silicon substrate, the negative photosensitive resin composition may be applied on the substrate by rotating the substrate. At this time, by adjusting the rotation rate, a film thickness of the photosensitive material film on the substrate may be readily adjusted.

Subsequently, by holding a mask for forming a target pattern over the photosensitive material film, a high energy beam of a wavelength of 190 to 500 nm such as an i-line and a g-line or an electron beam is used for irradiation such that an exposure dose is about 1 to 5,000 mJ/cm², preferably about 100 to 2,000 mJ/cm².

Next, a heat treatment after exposure (post-exposure bake (PEB)) is performed on a hot plate at 60 to 150°C for 50 to 600 seconds, preferably at 80 to 120°C for 60 to 300 seconds.

Subsequently, the development is applied. In the inventive negative photosensitive resin composition, an alkaline development using an alkaline aqueous solution may be applied.

Examples of the aqueous alkaline solution that can be favorably used for the alkali development include 2.38% aqueous tetramethylammonium hydroxide (TMAH) solution. The development may be performed according to an ordinary method such as a spray method and a paddle method, or by dipping in the developer, or the like. After that, as needs arise, by performing cleaning, rinsing, drying or the like, a resist film having a desired pattern may be obtained.

### (Method for Forming Cured Film)

The film having a pattern obtained by the patterning process may be baked and post-cured with an oven or a hot plate at a temperature of 100 to 300°C, preferably 150 to 300°C, more preferably 180 to 250°C to form a cured film. The post-curing temperature of 100 to 300°C allows the film of the negative photosensitive resin composition to increase the crosslinking density and to remove remaining volatile components. Thus, this temperature range is preferable in view of adhesiveness to a substrate, heat resistance, strength, and electronic characteristics. The time for the post-curing can be 10 minutes to 10 hours.

The formed pattern is used for the purpose of a protective coating for covering wirings, circuits and substrates, and the like. The formed patterns and protective coatings, while having excellent insulation property, have excellent adhesive force on a metal layer such as Cu of wirings and circuits to be covered, on a metal electrode existing on the substrate, or on an insulating substrate such as SiN existing in wirings and circuits to be covered, and make it possible, while having the mechanical strength appropriate as a protective coating, to remarkably improve the resolution performance for enabling a finer pattern formation.

### (Cured Film)

The cured film thus obtained is excellent in the adhesiveness to the substrate, heat resistance, electric characteristics, mechanical strength and chemical resistance to an alkaline release liquid, and the like, and also excellent in reliability of a semiconductor device using the film as a protective coating. In particular, it is possible to prevent occurrence of cracks in the temperature cycle test, and it can be suitably used as a protective coating (an interlayer insulation film or a surface protective film) for electric and electronic parts, a semiconductor device, and the like.

That is, the present invention provides an interlayer insulation film or a surface protective film made of the cured film obtained by curing the negative photosensitive resin composition.

The above protective coating is useful for an insulator film for a semiconductor device including rewiring use, an insulator film for a multilayer printed substrate, a solder mask, and a cover lay film, etc. because of its heat resistance, chemical resistance, and insulating property.

Furthermore, the present invention provides an electronic component having the interlayer insulation film or the surface protective film. Such an electronic component becomes excellent in reliability because the electronic component has the protective coating (interlayer insulation film or surface protective film) having heat resistance, chemical resistance, and the insulation property.

### EXAMPLE

Hereinafter, the present invention will be specifically described with reference to Synthesis Examples, Examples, and Comparative Examples. However, the present invention is not limited to the following examples. Note that the weight-average molecular weight

(Mw) indicates a weight-average molecular weight measured by GPC in terms of polystyrene.

### I. Synthesis of Alkali-Soluble Resin (A)

In the following Synthesis Examples, chemical structures and names of the used compounds are shown below.

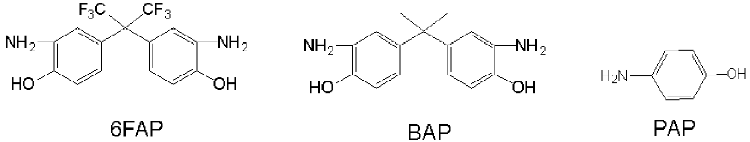

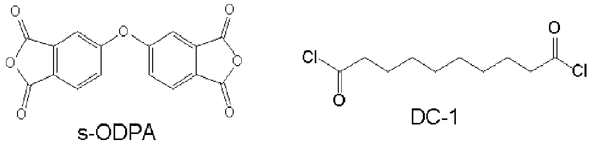

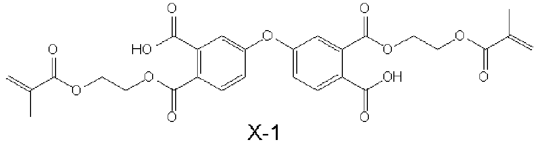

### [Synthesis Example 1] Synthesis of Polyimide Resin (A1)

Into a 1-L flask provided with a stirrer and a thermometer, 30 g (81.9 mmol) of 2,2-bis(3-amino-4-hydroxyphenyl)hexafluoropropane (6FAP), 0.9 g (8.6 mmol) of 4-aminophenol (PAP), and 125 g of N-methyl-2-pyrrolidone were added, followed by dissolving by stirring at room temperature. Next, under room temperature, a solution in which 26.7 g (86.2 mmol) of 3,3',4,4'-oxydiphthalic dianhydride (s-ODPA) was dissolved in 270 g of N-methyl-2-pyrrolidone was dropped thereto, after dropping, followed by stirring for 3 hours under room temperature. Thereafter, 40 g of xylene was added to the reaction liquid, followed by heating and refluxing for 3 hours while removing water generated at 170°C outside the system. After cooling to room temperature, the reaction liquid was dropped into 2 L of ultrapure water under stirring, a precipitate was filtered to be washed appropriately with water, followed by drying under reduced pressure at 40°C for 48 hours. Thus, a polyimide resin (A1) was obtained. A molecular weight of the polymer was measured by GPC. A weight-average molecular weight was 35,000 in terms of polystyrene.

### [Synthesis Example 2] Synthesis of Polyimide Resin (A2)

A polyimide resin (A2) was obtained by the same method as Synthesis Example 1, except that the 30 g (81.9 mmol) of 2,2-bis(3-amino-4-hydroxyphenyl)hexafluoropropane (6FAP) was changed to 21.2 g (81.9 mmol) of 2,2-bis(3-amino-4-hydroxyphenyl)propane (BAP). A molecular weight of the polymer was measured by GPC. A weight-average molecular weight was 34,000 in terms of polystyrene.

### [Synthesis Example 3] Synthesis of Polyamide-Imide Resin (A3)

Into a 500-ml flask provided with a stirrer and a thermometer, 28.5 g (77.8 mmol) of 2,2-bis(3-amino-4-hydroxyphenyl)hexafluoropropane (6FAP), 0.9 g (8.2 mmol) of 4-aminophenol (PAP), and 118 g of N-methyl-2-pyrrolidone were added, followed by dissolving by stirring at room temperature. Next, under room temperature, a solution in which 19.0 g (61.4 mmol) of 3,3',4,4'-oxydiphthalic dianhydride (s-ODPA) was dissolved in 192 g of N-methyl-2-pyrrolidone was dropped thereto, after dropping, followed by stirring for 3 hours under room temperature. Thereafter, 40 g of xylene was added to the reaction liquid, followed by heating and refluxing for 3 hours while removing water generated at 170°C outside the system. After cooling to room temperature, 3.2 g (41.0 mmol) of pyridine was added thereto, and 4.9 g (20.5 mmol) of sebacoyl dichloride (DC-1) was dropped thereto so as to keep the temperature to 5°C or lower. After completion of the dropping, the temperature was returned to room temperature, and the reaction liquid was dropped into 2 L of ultrapure water under stirring. A precipitate was filtered to be washed appropriately with water, followed by drying under reduced pressure at 40°C for 48 hours. Thus, a polyamide-imide resin (A3) was obtained. A molecular weight of the polymer was measured by GPC. A weight-average molecular weight was 35,000 in terms of polystyrene.

### [Synthesis Example 4] Synthesis of Polyamide Resin (A4)

Into a 500-ml flask provided with a stirrer and a thermometer, 28.5 g (77.8 mmol) of 2,2-bis(3-amino-4-hydroxyphenyl)hexafluoropropane (6FAP), 0.9 g (8.2 mmol) of 4-aminophenol (PAP), and 118 g of N-methyl-2-pyrrolidone were added, followed by dissolving by stirring at room temperature. Next, 13.0 g (163.8 mmol) of pyridine was added thereto, and 19.6 g (81.9 mmol) of sebacoyl dichloride (DC-1) was dropped thereto so as to keep the temperature to 5°C or lower. After completion of the dropping, the temperature was returned to room temperature, and the reaction liquid was dropped into 2 L of ultrapure water under stirring. A precipitate was filtered to be washed appropriately with water, followed by drying under reduced pressure at 40°C for 48 hours. Thus, a polyamide resin (A4) was obtained. A molecular weight of the polymer was measured by GPC. A weight-average molecular weight was 38,000 in terms of polystyrene.

### [Synthesis Example 5] Synthesis of Tetracarboxylic Diester Compound (X-1)

Into a 3-L flask provided with a stirrer and a thermometer, 100 g (322 mmol) of 3,3',4,4'-oxydiphthalic dianhydride (s-ODPA), 65.2 g (644 mmol) of triethylamine, 39.3 g (322 mmol) of N,N-dimethyl-4-aminopyridine, and 400 g of γ-butyrolactone were added, under stirring at room temperature, 83.8 g (644 mmol) of hydroxyethylmethacrylate (HEMA) was dropped thereto, followed by stirring for 24 hours under room temperature. After that, 370 g of a 10% aqueous solution of hydrochloric acid was dropped under ice cooling to stop the reaction. To the reaction liquid, 800 g of 4-methyl-2-pentanone was added to sample an organic layer, followed by washing 6 times with 600 g of water. A solvent of the obtained organic layer was distilled and 180 g of a tetracarboxylic diester compound (X-1) was obtained.

### [Synthesis Example 6] Synthesis of Polyimide Precursor (A5)

Into a 1-L flask provided with a stirrer and a thermometer, 57.1 g (100 mmol) of (X-1) and 228 g of N-methyl-2-pyrrolidone were added, followed by dissolving by stirring at room temperature. Next, under ice cooling, 24.4 g (205 mmol) of thionyl chloride was dropped thereto so as to keep the reaction solution temperature to 10°C or lower. After completion of the dropping, the solution was stirred under ice cooling for 2 hours. Subsequently, a solution obtained by dissolving 34.8 g (95 mmol) of 2,2-bis(3-amino-4-hydroxyphenyl)hexafluoropropane (6FAP), 1.1 g (10 mmol) of 4-aminophenol (PAP), and 32.4 g (410 mmol) of pyridine with 144 g of N-methyl-2-pyrrolidone was dropped thereto under ice cooling so as to keep the reaction solution temperature to 10°C or lower. After completion of the dropping, the temperature was returned to room temperature, and the reaction liquid was dropped into 3 L of water under stirring. A precipitate was filtered to be washed appropriately with water, followed by drying under reduced pressure at 40°C for 48 hours. Thus, a polyimide precursor (A5) was obtained. A molecular weight of the polymer was measured by GPC. A weight-average molecular weight was 36,000 in terms of polystyrene.

### II. Synthesis of Crosslinkable Polymer Compound (B)

### [Synthesis Example]

As a crosslinkable polymer compound (polymeric additive), various monomers were combined and copolymerized under a tetrahydrofuran solvent, a crystal was precipitated in hexane, dried, and polymer compounds (polymers B1 to B22 and comparative polymers C1 and C2) of the compositions shown below were obtained. The composition of the obtained polymer compounds was confirmed by 1H-NMR, and the molecular weight of the obtained polymer compounds was confirmed by gel permeation chromatography.

### [Synthesis Example 7] Polymer B1

Molecular weight (Mw) = 11,600

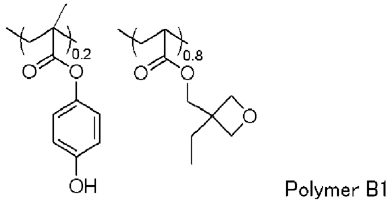

### [Synthesis Example 8] Polymer B2

Molecular weight (Mw) = 11,800

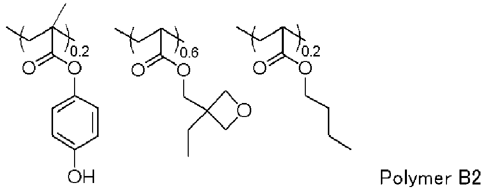

### [Synthesis Example 9] Polymer B3

Molecular weight (Mw) = 11,000

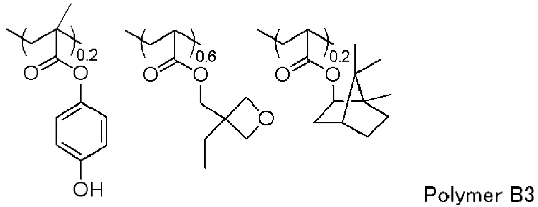

### [Synthesis Example 10] Polymer B4

Molecular weight (Mw) = 10,800

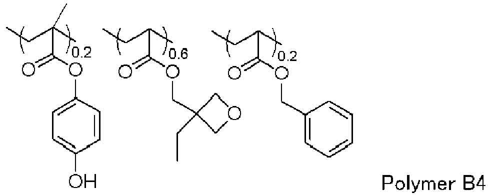

### [Synthesis Example 11] Polymer B5

Molecular weight (Mw) = 11,300

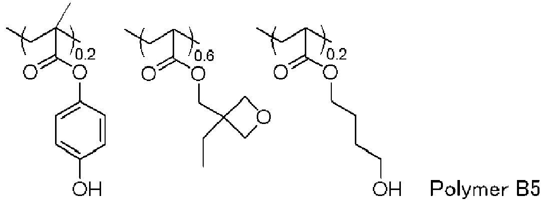

### [Synthesis Example 12] Polymer B6

Molecular weight (Mw) = 9,800

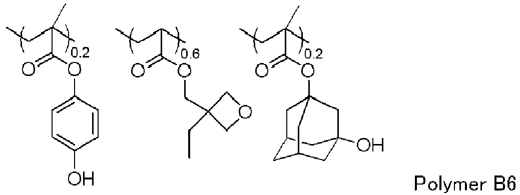

### [Synthesis Example 13] Polymer B7

Molecular weight (Mw) = 9,500

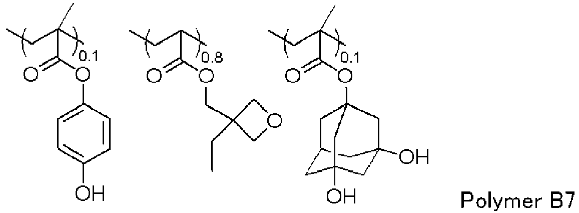

### [Synthesis Example 14] Polymer B8

Molecular weight (Mw) = 10,200

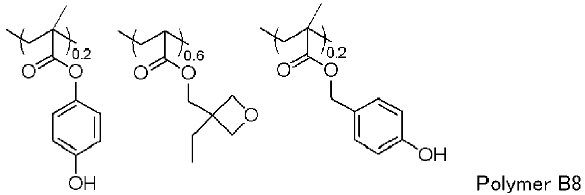

### [Synthesis Example 15] Polymer B9

Molecular weight (Mw) = 12,300

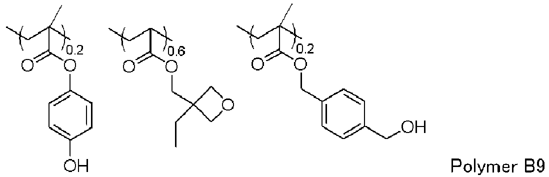

### [Synthesis Example 16] Polymer B10

Molecular weight (Mw) = 11,800

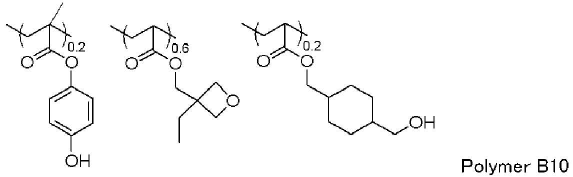

### [Synthesis Example 17] Polymer B11

Molecular weight (Mw) = 9,000

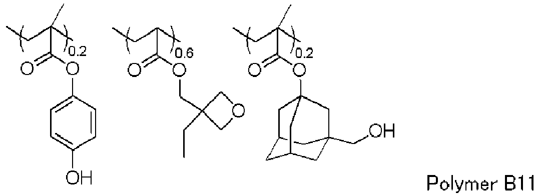

### [Synthesis Example 18] Polymer B12

Molecular weight (Mw) = 9,300

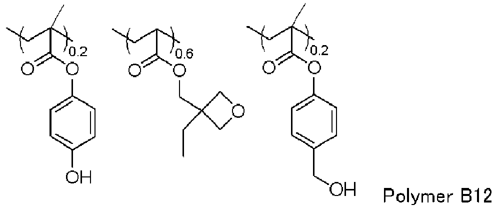

### [Synthesis Example 19] Polymer B13

Molecular weight (Mw) = 9,500

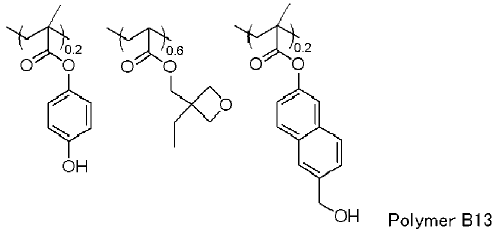

### [Synthesis Example 20] Polymer B14

Molecular weight (Mw) = 10,400

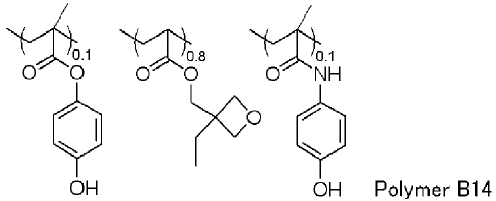

### [Synthesis Example 21] Polymer B15

Molecular weight (Mw) = 12,300

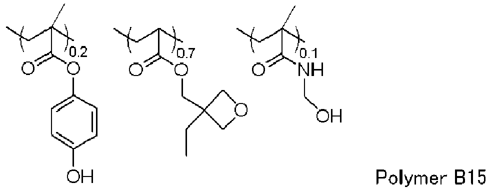

### [Synthesis Example 22] Polymer B16

Molecular weight (Mw) = 12,300

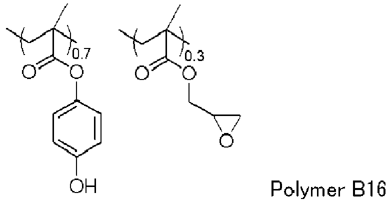

### [Synthesis Example 23] Polymer B17

Molecular weight (Mw) = 11,300

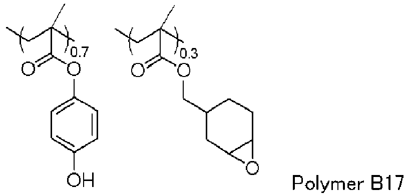

### [Synthesis Example 24] Polymer B18

Molecular weight (Mw) = 11,700

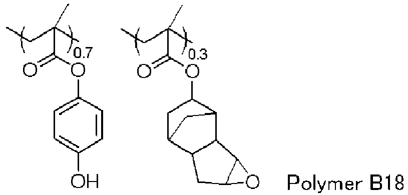

### [Synthesis Example 25] Polymer B19

Molecular weight (Mw) = 11,300

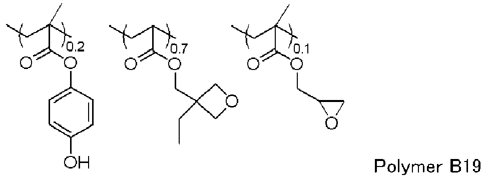

### [Synthesis Example 26] Polymer B20

Molecular weight (Mw) = 12,300

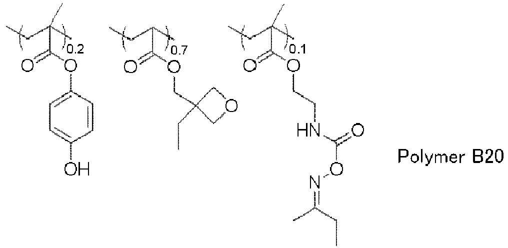

### [Synthesis Example 27] Polymer B21

Molecular weight (Mw) = 11,300

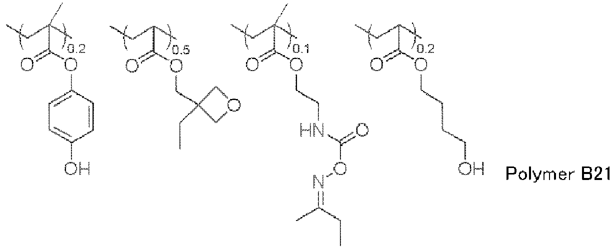

### [Synthesis Example 28] Polymer B22

Molecular weight (Mw) = 10,300

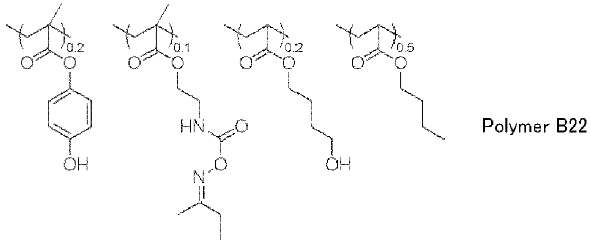

### [Synthesis Example 29] Comparative polymer C1

Molecular weight (Mw) = 11,900

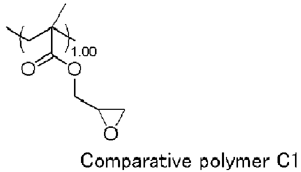

### [Synthesis Example 30] Comparative polymer C2

Molecular weight (Mw) = 10,600

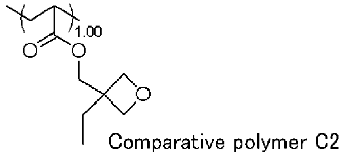

### III. Preparation of Negative Photosensitive Resin Composition

70 parts by mass of the alkali-soluble resins (A1) to (A5) synthesized in the Synthesis Example 1 to Synthesis Example 6 and 30 parts by mass of the crosslinkable polymer compounds (B1) to (B22), (C1) and (C2) synthesized in Synthesis Example 7 to Synthesis Example 30, and the comparative polymer (C3) shown below in this proportion were used as a base resin. With the compositions and blending amounts described in Table 1, 20 mass% resin compositions in terms of resin were prepared. Thereafter, after stirring, mixing, and dissolving, micro-filtering was applied with a Teflon (registered trade mark) 1.0-µm filter to obtain a negative photosensitive resin composition. In the Table, PGMEA of a solvent represents propylene glycol monomethyl ether acetate and GBL represents γ-butyrolactone.

**[Table 1]**

| | Resin | | Acid generator | Crosslinking agent | | | Basic compound | Thermal acid generator | Antioxidant | Silane compound | Dissolution inhibitor | Surfactant | Solvent | |
|---|---|---|---|---|---|---|---|---|---|---|---|---|---|---|
| | Component (A) | Component (B) | component (C) | Component (D) | | | Component (E) | Component (F) | Component (G) | Component (H) | Component (I) | Component (J) | Component (K) | |
| Photosensitive composition 1 | A1 | B1 | PAG-1 | CL-1 | CL-2 | | E-1 | F-1 | | | | J-1 | PGMEA | |
| | 70 parts by weight | 30 parts by weight | 3 parts by weight | 5 parts by weight | 10 parts by weight | | 1 part by weight | 1 part by weight | | | | 0.02 parts by weight | 400 parts by weight | |
| Photosensitive resin composition 2 | A2 | B1 | PAG-1 | CL-1 | CL-2 | | E-1 | F-1 | | | | J-1 | | GBL |
| | 70 parts by weight | 30 parts by weight | 3 parts by weight | 5 parts by weight | 10 parts by weight | | 1 part by weight | 1 part by weight | | | | 0.02 parts by weight | | 525 parts by weight |
| Photosensitive composition 3 | A3 | B1 | PAG-1 | CL-1 | CL-2 | | E-1 | F-1 | | | | J-1 | PGMEA | |
| | 70 parts by weight | 30 parts by weight | 3 parts by weight | 5 parts by weight | 10 parts by weight | | 1 part by weight | 1 part by weight | | | | 0.02 parts by weight | 400 parts by weight | |
| Photosensitive resin compositon 4 | A4 | B1 | PAG-1 | CL-1 | CL-2 | | E-1 | F-1 | | | | J-1 | PGMEA | |
| | 70 parts by weight | 30 parts by weight | 3 parts by weight | 5 parts by weight | 10 parts by weight | | 1 part by weight | 1 part by weight | | | | 0.02 parts by weight | 400 parts by weight | |
| Photosensitive composition 5 | A5 | B1 | PAG-1 | CL-1 | CL-2 | | E-1 | F-1 | | | | J-1 | PGMEA | |
| | 70 parts by weight | 30 parts by weight | 3 parts by weight | 5 parts by weight | 10 parts by weight | | 1 part by weight | 1 part by weight | | | | 0.02 parts by weight | 400 parts by weight | |
| Photosensitive resin compositon 6 | A1 | | PAG-1 | CL-1 | CL-2 | CL-3 | E-1 | F-1 | G-1 | H-1 | I-1 | J-1 | PGMEA | |
| | 70 parts by weight | 30 B1parts by weight | 3 parts by weight | 5 parts by weight | 10 parts by weight | 10 parts by weight | 1 part by weight | 1 part by weight | 1 part by weight | 0. 5 parts by weight | 5 parts by weight | 0.02 parts by weight | 426 parts by weight | |
| Photosensitive resin composition 7 | A1 | B1 | PAG-1 | CL-1 | CL-2 | | E-1 | F-2 | | | | J-1 | PGMEA | |
| | 70 parts by weight | 30 parts by weihgt | 3 parts by weight | 5 parts by weight | 10 parts by weight | | 1 part by weight | 1 part by weight | | | | 0.02 parts by weight | 400 parts by | |
| Photosensitive resin composition 8 | A1 70 parts by weight | B2 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts | |
| Photosensitive resin composition 9 | A1 70 parts by weight | B3 30 parts >v weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 10 | A1 70 parts by weight | B4 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 11 | A1 70 parts by weight | B5 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| | A 1 70 parts by weight | B6 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 13 | A1 70 parts | B7 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 14 | A 1 70 parts by weight | B8 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 40 0 parts by weight | |
| Photosensitive resin composition 15 | A1 70 parts by weight | B9 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 16 | A1 70 parts by weight | B10 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 17 | A1 70 parts by weight | B11 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 18 | A1 70 parts by weight | B12 30 parts weight | PAG-1 3 partsby weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 19 | A1 70 parts by weight | B13 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 20 | A1 70 parts by weight | B14 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 21 | A1 70 parts by weight | B15 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 22 | A1 70 parts by weight | B16 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 23 | A1 70 parts by weight | B17 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 24 | A1 70 parts by weight | B18 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 40 0 parts by weight | |
| Photosensitive resin composition 25 | A1 70 parts by weight | B19 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Photosensitive resin composition 26 | A1 70 parts by weight | B20 30 parts by weight | PAG-1 3 parts by weight | CL-1 5 parts by weight | CL-2 10 parts by weight | | E-1 1 part by | F-1 1 part by weight | | | | J-1 0.02 parts by weight | PGMEA 400 parts by weight | |
| Photosensitive resin composition 27 | A1 70 parts by weight | B21 30 parts by weight | PAG-1 3 parts by weight | CL-1 5 parts by weight | CL-2 10 parts by weight | | E- 1 1 part by weight | F-1 1 part by weight | | | | J-1 0.02 parts by weight | PGMEA 40 0 parts by weight | |
| Photosensitive resin composition 28 | A1 70 parts by weight | B22 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Comparative photosensitive resin composition 1 | A1 70 parts by weight | C1 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Comparative photosensitive resin composition 2 | A1 70 parts by weight | C2 30 parts by weight | PAG-1 3 parts by weight | CL-1 5 parts by weight | CL-2 10 parts by weight | | E-1 1 part by weight | F-1 1 part by weight | | | | J-1 0.02 parts by weight | PGMEA 400 parts by weight | |
| Comparative photosensitive resin composition 3 | A1 70 parts by weight | C3 30 parts by weight | PAG-1 3 parts by weight | CL-1 5 parts by weight | CL-2 10 parts by weight | CL-3 15 parts by weight | E-1 1 part by weight | F-1 1 part by weight | | | | J-1 0.02 parts by weight | PGMEA 400 parts by weight | |
| Comparative photosensitive resin composition 4 | A3 100 parts by weight | | PAC- 1 20 parts by weight | CL-2 10 parts by weight | CL-4 15 parts by weight | | | | | | | J-1 0.02 parts by weight | PGMEA 319 parts by weight | GBL 355 parts by weight |

In Table 1, details of the photo-acid generator (PAG-1), being an oximesulfonate compound, the photosensitizer (PAC-1), being a quinonediazide compound, the crosslinking agents (CL-1), (CL-2), (CL-3), and (CL-4), the basic compound (E-1), the thermal acid generators (F-1) and (F-2), the antioxidant (G-1), the silane compound (H-1), the dissolution inhibitor (I-1), the surfactant (J-1), and the novolak resin (C3) are as follows.

### Photo-acid generator (PAG-1)

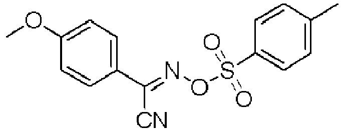

### Photosensitizer (PAC-1)

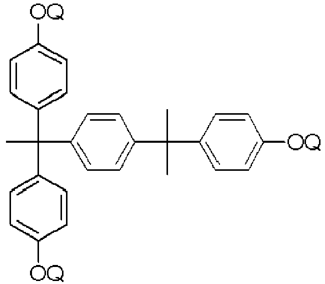

In the formula, Q represents a 1,2-naphthoquinone diazide sulfonyl group represented by the following formula (23) or a hydrogen atom, and 90% of Qs are substituted with the 1,2-naphthoquinone diazide sulfonyl group represented by the following formula (23).

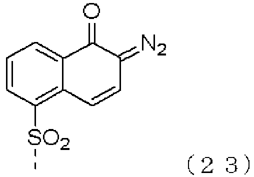

### Crosslinking agent (CL-1)

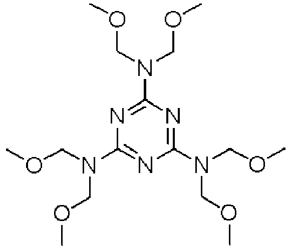

### Crosslinking agent (CL-2)

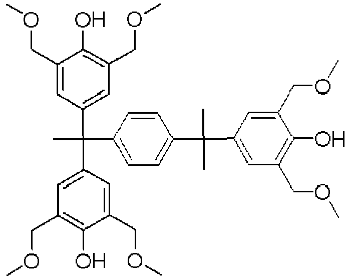

### Crosslinking agent (CL-3)

Oxetane resin: OXT-121 manufactured by TOAGOSEI CO., LTD.

### Crosslinking agent (CL-4)

### Epoxy resin: EP4000L manufactured by ADEKA CORPORATION

### Basic compound (E-1)

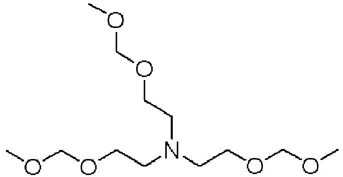

### Thermal acid generator (F-1)

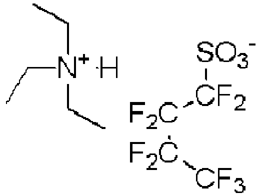

### Thermal acid generator (F-2)

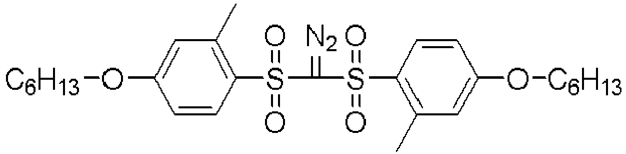

### Antioxidant (G-1)

Hindered phenol-based antioxidant: Sumilizer GA-80 manufactured by Sumitomo Chemical Co., Ltd.

### Silane compound (H-1)

Amino silane coupling agent: KBM-573 manufactured by Shin-Etsu Chemical Co., Ltd.

### Dissolution inhibitor (I-1)

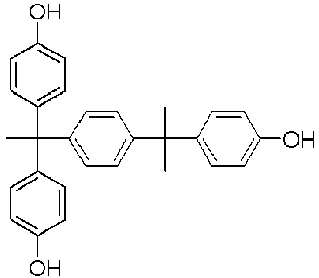

### Surfactant (J-1)

Fluorinated surfactant: PF-6320 manufactured by OMNOVA Solutions Inc.

### Comparative polymer C3

Phenolic novolak resin: EP6030G manufactured by Asahi Organic Chemicals Industry Co., Ltd.

### IV. Pattern Formation

By rotating a substrate after each of the photosensitive resin compositions 1 to 28 and comparative photosensitive resin compositions 1 to 4 was dispensed by 5 mL on a silicon substrate treated with hexamethylsilazane, that is, by a spin-coating method, the photosensitive resin composition was applied such that a film thickness was 2 µm after patterning and heating for the post-curing. That is, by studying in advance that after the post-curing step, the film thickness decreases, the rotational rate during coating was adjusted such that a finishing film thickness after the post-curing was 2 µm.

Next, pre-baking was performed on a hot plate at 100°C for 2 minutes. Then, i-line exposure was carried out using an i-line stepper AP300E manufactured by Veeco Instruments Inc. After the irradiation, post-exposure baking (PEB) was performed at 110°C for 2 minutes, and the resultant was then cooled. In the pattern formation, a mask for a negative pattern was used. The mask has a pattern which can form a line-and-space pattern (hereinafter, noted as LS pattern) of 2 µm in lengthwise and breadthwise arrangement of 1:1, and can form an LS pattern of 1 µm in increments from 10 µm to 2 µm.

Subsequently, a 2.38% aqueous tetramethylammonium hydroxide (TMAH) solution was used as a developer, and a 1-minute paddle development was carried out until the coating film of the unexposed part was dissolved. Then, rinsing with ultrapure water was carried out.

Subsequently, the substrate with the pattern was post-cured by using an oven at 180°C for 2 hours while purging with nitrogen.

Next, in order to observe the shape of the obtained LS pattern, each substrate was cut out, and the line pattern shape was observed using a scanning electron microscope (SEM). The shape of the 2-µm LS line pattern after post-curing was evaluated. Together with these results, Table 2 shows the sensitivity and the number of times the development was performed at which the 2-µm pattern was formed.

The shape of the LS pattern was evaluated based on the following criteria, and the evaluation results are shown in Table 2. The pattern cross section of the smallest LS line was observed, and the widths of the pattern cross section at the top and the bottom were compared. When the difference was 0 µm or more and 0.2 µm or less, the pattern was rated as "A", when more than 0.2 µm and 0.5 µm or less, the pattern was rated as "B", when more than 0.5 µm and 1.0 µm or less, the pattern was rated as "C", and when over 1.0 µm, the pattern was rated as "D".

### V. Rupture Elongation and Tensile Strength

Each of the photosensitive resin compositions 1 to 28 and the comparative photosensitive resin compositions 1 to 4 was applied onto an aluminum substrate by spin-coating so that a finishing film thickness after curing was 10 µm. Next, pre-baking was performed on a hot plate at 100°C for 4 minutes to obtain a photosensitive resin film.

Subsequently, contact exposure was performed on the entire surface of the substrate by using a contact aligner UL-7000 manufactured by Quintel Co., Ltd. with a wavelength in a broadband and an exposure dose of 500 mJ/cm². After irradiation, a PEB treatment was carried out at 110°C for 4 minutes, and then the substrate was cooled. Thereafter, curing was performed with an oven at 180°C for 2 hours while purging with nitrogen to obtain a photosensitive resin cured film. Next, a wafer with a cured film was cut in strips of a width of 10 mm and a length of 60 mm, followed by peeling of the cured film from the substrate by dipping in hydrochloric acid of 20 mass%. The obtained cured film was subjected to a measurement of the rupture elongation and tensile strength by using an Autograph AGX-1KN manufactured by Shimadzu Corporation. The measurement was performed 10 times per sample, and an average value thereof is shown in Table 2.

**[Table 2]**

| | | Pattern shape | Number of times development was performed (Puddle times) | Sensitivity (mJ/cm²) | Rupture elongation (%) | Tensile strength (MPa) |
|---|---|---|---|---|---|---|
| Example 1 | Photosensitive resin composition 1 | A | 60 sec × 2 | 860 | 13 | 102 |
| Example 2 | Photosensitive resin composition 2 | A | 60 sec × 2 | 940 | 12 | 108 |
| Example 3 | Photosensitive resin composition 3 | A | 60 sec × 2 | 800 | 13 | 105 |
| Example 4 | Photosensitive resin composition 4 | A | 60 sec × 1 | 820 | 30 | 95 |
| Example 5 | Photosensitive resin composition 5 | B | 60 sec × 2 | 900 | 23 | 105 |
| Example 6 | Photosensitive resin composition 6 | A | 60 sec × 1 | 920 | 22 | 110 |
| Example 7 | Photosensitive resin composition 7 | A | 60 sec × 2 | 800 | 20 | 103 |
| Example 8 | Photosensitive resin composition 8 | A | 60 sec × 2 | 900 | 26 | 107 |
| Example 9 | Photosensitive resin composition 9 | A | 60 sec × 2 | 900 | 32 | 104 |
| Example 10 | Photosensitive resin composition 10 | A | 60 sec × 2 | 940 | 20 | 114 |
| Example 11 | Photosensitive resin composition 11 | A | 60 sec × 1 | 980 | 29 | 104 |
| Example 12 | Photosensitive resin composition 12 | A | 60 sec × 1 | 920 | 25 | 110 |
| Example 13 | Photosensitive resin composition 13 | A | 60 sec × 1 | 830 | 26 | 116 |
| Example 14 | Photosensitive resin composition 14 | A | 60 sec × 2 | 840 | 24 | 112 |
| Example 15 | Photosensitive resin composition 15 | A | 60 sec × 2 | 820 | 32 | 110 |
| Example 16 | Photosensitive resin composition 16 | A | 60 sec × 1 | 970 | 36 | 112 |
| Example 17 | Photosensitive resin composition 17 | A | 60 sec × 2 | 850 | 28 | 107 |
| Example 18 | Photosensitive resin composition 18 | A | 60 sec × 2 | 880 | 29 | 114 |
| Example 19 | Photosensitive resin composition 19 | B | 60 sec × 2 | 880 | 20 | 120 |
| Example 20 | Photosensitive resin composition 20 | A | 60 sec × 1 | 980 | 24 | 110 |
| Example 21 | Photosensitive resin composition 21 | A | 60 sec × 1 | 1000 | 26 | 108 |
| Example 22 | Photosensitive resin composition 22 | A | 60 sec × 2 | 1000 | 28 | 118 |
| Example 23 | Photosensitive resin composition 23 | A | 60 sec × 2 | 1080 | 22 | 120 |
| Example 24 | Photosensitive resin composition 24 | A | 60 sec × 2 | 1080 | 20 | 122 |
| Example 25 | Photosensitive resin composition 25 | A | 60 sec × 2 | 980 | 30 | 115 |
| Example 26 | Photosensitive resin composition 26 | A | 60 sec × 2 | 860 | 13 | 102 |
| Example 27 | Photosensitive resin composition 27 | A | 60 sec × 1 | 980 | 29 | 104 |
| Example 28 | Photosensitive resin composition 28 | A | 60 sec × 2 | 920 | 36 | 106 |
| Comparative Example 1 | Comparative photosensitive resin composition 1 | 2 µm LS pattern not resolved | - | - | 20 | 102 |
| Comparative Example 2 | Comparative photosensitive resin composition 2 | 2 µm LS pattern not resolved | - | - | 22 | 103 |
| Comparative Example 3 | Comparative photosensitive resin composition 3 | A | 60 sec × 2 | 700 | Film was brittle and not possible to measure | Film was brittle and not possible to measure |
| Comparative Example 4 | Comparative photosensitive resin composition 4 | D | 60 sec × 3 | 400 | 12 | 120 |

### VI. Adhesion

According to the same procedure as the above-described pattern formation, the photosensitive resin compositions 1 to 28 and comparative photosensitive resin compositions 3 and 4 were used. A 1-cm-square square pattern was i-line exposed to obtain a gridlike pattern on the entire surface of the substrate so that a finishing film thickness on the SiN substrate after curing was 5 µm. The exposure dose was the exposure dose at which the smallest pattern was successfully formed, determined in the LS pattern evaluation. In the pre-baking, treatment was performed at 100°C for 4 minutes, and in the PEB, at 110°C for 4 minutes. Regarding the development, a 1-minute paddle development was performed until the coating film in the unexposed parts dissolved, over a prescribed number of times.

Subsequently, purging with nitrogen was carried out at 180°C for 2 hours, and the substrate with the pattern was post-cured. Next, the cured substrate was cut into individual pieces along the 1 cm square pattern to obtain chips with cured films. An aluminum pin with epoxy resin was made to stand on an obtained chip, this was heated at 150°C for 1 hour to make the aluminum pin adhere to the chip, and thus, a measurement sample was fabricated. After cooling, adhesive force was measured by using ROMULUS manufactured by Quad Group Inc., according to the method shown in FIG. 1 (hereinafter, noted as the Stud-pull method). As the measurement condition, the measurement was performed at a measurement speed of 20 N/sec. FIG. 1 is an explanatory diagram illustrating the adhesive force measurement method. In FIG. 1, 1 denotes a SiN substrate (a substrate), 2 denotes a cured film, 3 denotes an aluminum pin with adhesive, 4 denotes a support, 5 denotes a grip, and 6 denotes a tensile direction. The obtained value was an average value of ten measurement points. The larger the numerical value, the higher the adhesiveness of the cured film to a SiN substrate. In addition, the adhesive force at the peeling interface of cured film/adhesive is higher than that of substrate/cured film. The obtained numerical values and the peeling interfaces were compared to evaluate the adhesiveness.

Furthermore, as a high temperature and high humidity test, the obtained chip was left to stand under saturated 2 atmospheres at 120°C in a 100% RH pressure cooker for 168 hours. Subsequently, the adhesive force after the test was evaluated by the Stud-pull method. The results are shown in Table 3 as the adhesive force to a substrate together with the results before the test.

**[Table 3]**

| | | Adhesive force (MPa) | | Peeling interface | |
|---|---|---|---|---|---|
| | | Before PCT test | After PCT test | Before PCT test | After PCT test |
| Example 1 | Photosensitive resin composition 1 | 49 | 50 | Cured film/adhesive | Cured film/adhesive |
| Example 2 | Photosensitive resin composition 2 | 53 | 55 | Cured film/adhesive | Cured film/adhesive |
| Example 3 | Photosensitive resin composition 3 | 56 | 55 | Cured film/adhesive | Cured film/adhesive |
| Example 4 | Photosensitive resin composition 4 | 58 | 58 | Cured film/adhesive | Cured film/adhesive |
| Example 5 | Photosensitive resin composition 5 | 54 | 54 | Cured film/adhesive | Cured film/adhesive |
| Example 6 | Photosensitive resin composition 6 | 52 | 53 | Cured film/adhesive | Cured film/adhesive |
| Example 7 | Photosensitive resin composition 7 | 57 | 56 | Cured film/adhesive | Cured film/adhesive |
| Example 8 | Photosensitive resin composition 8 | 56 | 55 | Cured film/adhesive | Cured film/adhesive |
| Example 9 | Photosensitive resin composition 9 | 58 | 57 | Cured film/adhesive | Cured film/adhesive |
| Example 10 | Photosensitive resin composition 10 | 59 | 60 | Cured film/adhesive | Cured film/adhesive |
| Example 11 | Photosensitive resin composition 11 | 49 | 48 | Cured film/adhesive | Cured film/adhesive |
| Example 12 | Photosensitive resin composition 12 | 51 | 50 | Cured film/adhesive | Cured film/adhesive |
| Example 13 | Photosensitive resin composition 13 | 47 | 50 | Cured film/adhesive | Cured film/adhesive |
| Example 14 | Photosensitive resin composition 14 | 48 | 49 | Cured film/adhesive | Cured film/adhesive |
| Example 15 | Photosensitive resin composition 15 | 55 | 54 | Cured film/adhesive | Cured film/adhesive |
| Example 16 | Photosensitive resin composition 16 | 58 | 58 | Cured film/adhesive | Cured film/adhesive |
| Example 17 | Photosensitive resin composition 17 | 53 | 52 | Cured film/adhesive | Cured film/adhesive |
| Example 18 | Photosensitive resin composition 18 | 55 | 56 | Cured film/adhesive | Cured film/adhesive |
| Example 19 | Photosensitive resin composition 19 | 55 | 56 | Cured film/adhesive | Cured film/adhesive |
| Example 20 | Photosensitive resin composition 20 | 52 | 53 | Cured film/adhesive | Cured film/adhesive |
| Example 21 | Photosensitive resin composition 21 | 59 | 60 | Cured film/adhesive | Cured film/adhesive |
| Example 22 | Photosensitive resin composition 22 | 56 | 53 | Cured film/adhesive | Cured film/adhesive |
| Example 23 | Photosensitive resin composition 23 | 58 | 57 | Cured film/adhesive | Cured film/adhesive |
| Example 24 | Photosensitive resin composition 24 | 60 | 59 | Cured film/adhesive | Cured film/adhesive |
| Example 25 | Photosensitive resin composition 25 | 61 | 62 | Cured film/adhesive | Cured film/adhesive |
| Example 26 | Photosensitive resin composition 26 | 49 | 50 | Cured film/adhesive | Cured film/adhesive |
| Example 27 | Photosensitive resin composition 27 | 56 | 53 | Cured film/adhesive | Cured film/adhesive |
| Example 28 | Photosensitive resin composition 28 | 60 | 59 | Cured film/adhesive | Cured film/adhesive |
| Comparative Example 3 | Comparative photosensitive resin composition 3 | 51 | 27 | Cured film/adhesive | Substrate/cured film |
| Comparative Example 4 | Comparative photosensitive resin composition 4 | 48 | 22 | Cured film/adhesive | Substrate/cured film |

As shown in Table 2, it has been revealed that the inventive negative photosensitive resin compositions resolve 2-µm LS patterns with better rectangularity than the negative photosensitive resin compositions of comparative photosensitive resin compositions 1 and 2 with added polymer compounds constituted only from crosslinkable groups, and the negative photosensitive resin compositions of comparative photosensitive resin composition 4 with added heat crosslinking agent. Meanwhile, with the comparative photosensitive resin composition 3, the film was brittle, and measurement of rupture elongation and tensile strength itself was impossible.

In addition, as shown in Table 3, it has been revealed that the inventive negative photosensitive resin composition can give a cured film having excellent mechanical characteristics and resistance to high temperature and high humidity even when cured at a low temperature of 200°C or lower. On the other hand, the cured films using the comparative photosensitive resin compositions 3 and 4 resulted in having degraded adhesive force after high temperature and high humidity compared with the cured films obtained from the inventive compositions.

From the above results, the following results have been achieved: the compositions of Examples 1 to 28 have favorable rectangularity, show excellent resolution that can resolve fine patterns of 2 µm, and show sufficient properties as photosensitive materials; at the same time, the cured films thereof have substrate adhesiveness and excellent resistance to high temperature and high humidity, and are useful as top coats for circuits and electronic components.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A negative photosensitive resin composition comprising:
(A) an alkali-soluble resin containing at least one or more structures selected from a polyimide structure, a polyamide structure, a polybenzoxazole structure, a polyamide-imide structure, and a precursor structure thereof;
(B) a crosslinkable polymer compound containing a structural unit represented by the following general formula (1) and having a group crosslinked with the component (A);
(C) a compound that generates an acid by light; and
(D) a crosslinking agent other than the component (B), 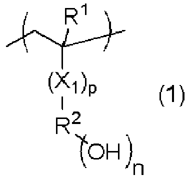 wherein R¹ represents a hydrogen atom or a methyl group, R² represents a linear, branched, or cyclic aliphatic saturated hydrocarbon group with a valency of (n+1) having 1 to 15 carbon atoms, an aromatic hydrocarbon group having 6 to 15 carbon atoms, a benzyl group, or a naphthalene methyl group, wherein a carbon atom of the aliphatic saturated hydrocarbon group is optionally substituted with an oxygen atom; "n" is an integer of 1 to 5; X₁ each represents -C(=O)-O-, -C(=O)-NH-, or - C(=O)-N(R³OH)-; R³ represents a divalent linear, branched, or cyclic aliphatic saturated hydrocarbon group having 1 to 12 carbon atoms, or an aromatic hydrocarbon group having 6 to 12 carbon atoms, wherein a carbon atom of the aliphatic saturated hydrocarbon group is optionally substituted with an oxygen atom; and "p" is 0 or 1.

2. The negative photosensitive resin composition according to claim 1, wherein the component (B) is a crosslinkable polymer compound containing a structural unit represented by the following general formula (2) and containing a structural unit represented by the following general formula (3), the structural unit having a group crosslinked with the component (A), 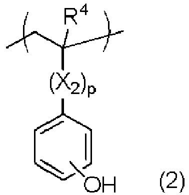 wherein R⁴ represents a hydrogen atom or a methyl group, X₂ each represents -C(=O)-O-, -C(=O)-NH-, or -C(=O)-N(R⁵OH)-; R⁵ represents a divalent linear, branched, or cyclic aliphatic saturated hydrocarbon group having 1 to 12 carbon atoms, or an aromatic hydrocarbon group having 6 to 12 carbon atoms, wherein a carbon atom of the aliphatic saturated hydrocarbon group is optionally substituted with an oxygen atom; and "p" is 0 or 1, 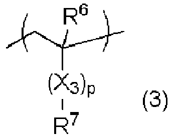 wherein R⁶ represents a hydrogen atom or a methyl group, R⁷ represents a group containing an oxazoline group, an isocyanate group, a blocked isocyanate group, an oxetanyl group, and an epoxy group, X₃ represents - C(=O)-O-, a phenylene group, or a naphthylene group; and "p" is 0 or 1.

3. The negative photosensitive resin composition according to claim 1 or 2, wherein the component (B) is a crosslinkable polymer compound containing a structural unit represented by the following general formula (2) and one or both of structural units represented by the following general formula (4) and the following general formula (4'), 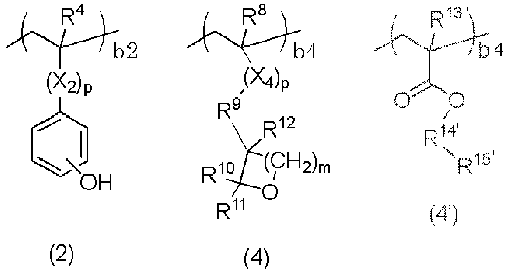 wherein R⁸ represents a hydrogen atom or a methyl group, X₄ each represents -C(=O)-O-, a phenylene group, or a naphthylene group; R⁹ represents a linear, branched, or cyclic alkylene group having 1 to 15 carbon atoms, optionally containing a hydroxy group, an ester group, an ether group, or an aromatic hydrocarbon, R¹⁰ represents a hydrogen atom, a linear, branched, or cyclic alkyl group having 1 to 6 carbon atoms, or is optionally bonded with R⁹ to form a ring; R¹¹ represents a hydrogen atom or a linear, branched, or cyclic alkyl group having 1 to 6 carbon atoms, R¹² represents a hydrogen atom or a linear alkyl group having 1 to 6 carbon atoms, and is optionally bonded with R⁹ to form a ring; "m" is 0 or 1; "p" is 0 or 1; R^{13'} represents a hydrogen atom or a methyl group, R^{14'} represents a single bond or an alkylene group, R^{15'} represents a blocked isocyanate group; 0 < b2 < 1.0, 0 ≤ b4 < 1.0, 0 ≤ b4' < 1.0, 0 < b4 + b4' < 1.0, 0 < b2 + b4 + b4' ≤ 1.0, or 0 < b2 + b4 ≤ 1.0 and 0 < b2 + b4' ≤ 1.0; R⁴ represents a hydrogen atom or a methyl group, X₂ each represents - C(=O)-O-, -C(=O)-NH-, or -C(=O)-N(R⁵OH)-; and R⁵ represents a divalent linear, branched, or cyclic aliphatic saturated hydrocarbon group having 1 to 12 carbon atoms, or an aromatic hydrocarbon group having 6 to 12 carbon atoms, wherein a carbon atom of the aliphatic saturated hydrocarbon group is optionally substituted with an oxygen atom.

4. The negative photosensitive resin composition according to any one of claims 1 to 3, wherein the component (B) is a crosslinkable polymer compound containing a structural unit represented by the following general formula (2), a structural unit represented by the following general formula (5), and one or both of structural units represented by the following general formula (4) and the following general formula (4'), 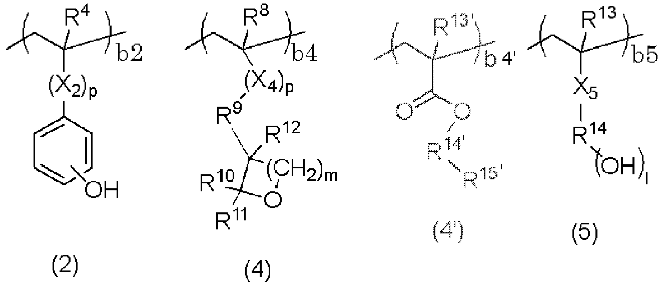 wherein R¹³ represents a hydrogen atom or a methyl group, R¹⁴ represents a linear, branched, or cyclic aliphatic saturated hydrocarbon group with a valency of (1+1) having 1 to 12 carbon atoms, wherein a carbon atom of the aliphatic saturated hydrocarbon group is optionally substituted with an oxygen atom; X₅ each represents - C(=O)-O-, -C(=O)-NH-, -C(=O)-N(R¹⁵OH)-, a phenylene group, or a naphthylene group; R¹⁵ represents a divalent linear, branched, or cyclic aliphatic saturated hydrocarbon group having 1 to 12 carbon atoms, or an aromatic hydrocarbon group having 6 to 12 carbon atoms, wherein a carbon atom of the aliphatic saturated hydrocarbon group is optionally substituted with an oxygen atom; "1" is 0 or 1; 0 < b2 < 1.0, 0 ≤ b4 < 1.0, 0 ≤ b4' < 1.0, 0 < b4 + b4' < 1.0, 0 ≤ b5 < 1.0, 0 < b2 + b4 + b4' + b5 ≤ 1.0, or 0 < b2 + b4 + b5 ≤ 1.0 and 0 < b2 + b4' + b5 ≤ 1.0; R⁴ represents a hydrogen atom or a methyl group, X₂ each represents -C(=O)-O-, -C(=O)-NH-, or -C(=O)-N(R⁵OH)-; R⁵ represents a divalent linear, branched, or cyclic aliphatic saturated hydrocarbon group having 1 to 12 carbon atoms, or an aromatic hydrocarbon group having 6 to 12 carbon atoms, wherein a carbon atom of the aliphatic saturated hydrocarbon group is optionally substituted with an oxygen atom; "p" is 0 or 1; R⁸ represents a hydrogen atom or a methyl group, X₄ each represents -C(=O)-O-, a phenylene group, or a naphthylene group; R⁹ represents a linear, branched, or cyclic alkylene group having 1 to 15 carbon atoms, optionally containing a hydroxy group, an ester group, an ether group, or an aromatic hydrocarbon, R¹⁰ represents a hydrogen atom, a linear, branched, or cyclic alkyl group having 1 to 6 carbon atoms, or is optionally bonded with R⁹ to form a ring; R¹¹ represents a hydrogen atom or a linear, branched, or cyclic alkyl group having 1 to 6 carbon atoms, R¹² represents a hydrogen atom or a linear alkyl group having 1 to 6 carbon atoms, and is optionally bonded with R⁹ to form a ring; "m" is 0 or 1; R^{13'} represents a hydrogen atom or a methyl group, R^{14'} represents a single bond or an alkylene group, and R^{15'} represents a blocked isocyanate group.

5. The negative photosensitive resin composition according to any one of claims 1 to 4, wherein the component (D) contains one or more kinds of crosslinking agents selected from an amino condensate modified by formaldehyde or formaldehyde-alcohol; and a phenol compound having two or more methylol groups or alkoxymethylol groups by average in one molecule.

6. The negative photosensitive resin composition according to any one of claims 1 to 5, containing 10 to 100 parts by mass of the component (B) relative to 100 parts by mass of the component (A).

7. The negative photosensitive resin composition according to any one of claims 1 to 6, further comprising one or more out of (E) a basic compound, (F) a thermal acid generator, (G) an antioxidant, and (H) a silane compound.

8. A patterning process comprising:
(1) forming a photosensitive material film by coating a substrate with the negative photosensitive resin composition according to any one of claims 1 to 7;
(2) subsequently, after a heat treatment, exposing the photosensitive material film with a high energy beam having a wavelength of 190 to 500 nm or an electron beam via a photomask; and
(3) after irradiation, developing the substrate, which has been heat-treated, with a developer of an alkaline aqueous solution.

9. A method for forming a cured film comprising:
heating and post-curing a film on which a pattern is formed by the patterning process according to claim 8 at a temperature of 100 to 300°C.

10. An interlayer insulation film, being a cured film by curing the negative photosensitive resin composition according to any one of claims 1 to 7.

11. A surface protective film, being a cured film by curing the negative photosensitive resin composition according to any one of claims 1 to 7.

12. An electronic component, having the interlayer insulation film according to claim 10 or the surface protective film according to claim 11.
